# EUROPEAN PATENT SPECIFICATION

(11) **EP 3 852 147 B1**
(45) Date of publication and mention of the grant of the patent: **07.01.2026**
(21) Application number: 20203368.4
(22) Date of filing: 22.10.2020
(51) Int. Cl.: G09G 3/3225, H10K 59/35, H10K 59/121

(54) **DISPLAY DEVICE AND ELECTRONIC APPARATUS**
ANZEIGEVORRICHTUNG UND ELEKTRONISCHE VORRICHTUNG
DISPOSITIF D'AFFICHAGE ET APPAREIL ÉLECTRONIQUE

(30) Priority: 17.01.2020 KR 20200006753
(43) Date of publication of application: 21.07.2021
(73) Proprietor: Samsung Display Co., Ltd., Yongin-si Gyeonggi-do 17113 (KR)
(72) Inventor: KO, Junhyeuk, Yongin-si Gyeonggi-do 17113 (KR); BAEK, Daewon, Yongin-si Gyeonggi-do 17113 (KR); KIM, Euigyu, Yongin-si Gyeonggi-do 17113 (KR); MIN, Soohyun, Yongin-si Gyeonggi-do 17113 (KR); SONG, Minchul, Yongin-si Gyeonggi-do 17113 (KR); LEE, Sangshin, Yongin-si Gyeonggi-do 17113 (KR); HONG, Seungjoo, Yongin-si Gyeonggi-do 17113 (KR)
(74) Representative: Marks & Clerk LLP

(56) References cited:
- CN-A- 107 633 802
- CN-A- 108 648 679
- CN-A- 109 599 052
- US-A1- 2017 317 150
- US-A1- 2020 111 401

## Description

### BACKGROUND

### FIELD

Embodiments/implementations of the invention relate generally to a display device and an electronic apparatus including the same.

### Discussion of the Background

Recently, the usage of display devices has diversified. In addition, as display devices have become thinner and lighter, their range of use has gradually been extended.

As the area occupied by a display area in display devices expands, various functions that are combined or associated with display devices have been added. In order to add various functions while expanding the area, research is being carried out on display devices having a region for adding various functions other than the display of images inside a display area.

To add various functions to a display device, a component such as a camera or a sensor may be arranged. To arrange a component while securing a display area having a larger area, a component may be arranged to overlap a display area.

The above information disclosed in this Background section is only for understanding of the background of the inventive concepts, and, therefore, it may contain information that does not constitute prior art.

CN 108648679 A relates to a driving method and a device of a display panel using such method.

CN 107633802 A relates to a display panel and a display device.

CN 109599052 A relates to a display panel and a display device.

### SUMMARY

As one of the methods of arranging a component, though a display device may include a transmission area through which a wavelength such as light or sound may pass, in the case where the transmission area is provided, a resolution may be reduced.

Embodiments provide a display device and an electronic apparatus configured to prevent or minimize resolution reduction and secure a wide area of a display area, and in which a component such as a sensor or a camera may be arranged. However, it should be understood that embodiments described herein should be considered in a descriptive sense only and not for limitation of the disclosure.

Additional features of the invention will be set forth in part in the description which follows and, in part, will be apparent from the description, or may be learned by practice of the presented embodiments of the inventive concepts.

An embodiment of the invention provides a display device as defined in claim 1.

A third distance between pixels of different colors that neighbor each other among the first pixels may be equal to or greater than a fourth distance between pixels of different colors that neighbor each other among the second pixels.

A size or a shape of the first pixels may be different from a size or a shape of the second pixels.

A pixel of a different color may be arranged between pixels of the same color that neighbor each other among the first pixels.

The second pixel units each include at least two pixels of the same color.

The display device may further include a plurality of light-emitting diodes respectively corresponding to the first pixels and the second pixels, wherein each of the plurality of light-emitting diodes may have a stacked structure of a pixel electrode, an emission layer, and an opposite electrode.

A first separation distance between pixel electrodes respectively corresponding to pixels having the same color that neighbor each other among the first pixels may be greater than a second separation distance between pixel electrodes respectively corresponding to pixels having the same color that neighbor each other among the second pixels.

The emission layers respectively corresponding to pixels of the same color that neighbor each other among the second pixels may be formed as a single body.

The opposite electrodes respectively corresponding to the first pixels and the second pixels may be formed as a single body and include a hole corresponding to the transmission area.

The display device may further include a bottom metal layer arranged between the substrate and the plurality of pixels and located in the second display area.

Another embodiment of the invention provides an electronic apparatus as defined in claim 9.

A third distance between pixels of different colors that neighbor each other among the first pixels may be equal to or greater than a fourth distance between pixels of different colors that neighbor each other among the second pixels.

A size or a shape of the first pixels may be different from a size or a shape of the second pixels.

The electronic apparatus may further include a plurality of light-emitting diodes respectively corresponding to the first pixels and the second pixels, and a plurality of thin film transistors respectively connected to the plurality of light-emitting diodes, wherein each of the plurality of light-emitting diodes may have a stacked structure of a pixel electrode, an emission layer, and an opposite electrode.

The electronic apparatus may further include a bottom metal layer arranged below thin film transistors located in the second display area among the plurality of thin film transistors.

A first separation distance between pixel electrodes respectively corresponding to pixels of the same color that neighbor each other among the first pixels may be greater than a second separation distance between pixel electrodes respectively corresponding to pixels of the same color that neighbor each other among the second pixels.

The emission layers respectively corresponding to pixels of the same color that neighbor each other among the second pixels may be formed as a single body.

The single body of the emission layers may cover a top surface of a pixel-defining layer covering edges of pixel electrodes respectively corresponding to pixels of the same color that neighbor each other among the second pixels.

A pixel of a different color may be located between pixels of the same color that neighbor each other among the first pixels.

The first pixel units each include at least one first red pixel, at least one first green pixel, and at least one first blue pixel, the second pixel units each include at least one second red pixel, at least one second green pixel, and at least one second blue pixel, and

The component may include a sensor or a camera.

These and/or other aspects will become apparent and more readily appreciated from the following description of the embodiments, the accompanying drawings, and claims.

At least some of the above and other features of the invention are set out in the claims.

It is to be understood that both the foregoing general description and the following detailed description are explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this specification, illustrate embodiments of the invention, and together with the description serve to explain the inventive concepts.
FIGS. 1A and 1B are perspective views illustrating an electronic apparatus including a display device according to an embodiment.
FIGS. 2A, 2B, and 2C are cross-sectional views illustrating a portion of an electronic apparatus including a display device according to an embodiment.
FIGS. 3A and 3B are plan views illustrating a display device according to an embodiment.
FIG. 4 is an equivalent circuit diagram illustrating a circuit connected to an organic light-emitting diode of a display device according to an embodiment.
FIG. 5A is a cross-sectional view illustrating a portion of a display device according to an embodiment.
FIG. 5B is a cross-sectional view illustrating a portion of a display device according to an embodiment.
FIG. 6 is a plan view illustrating a portion of a first display area of a display device according to an embodiment.
FIG. 7 is a plan view illustrating a portion of a second display area of a display device according to an embodiment.
FIG. 8 is a cross-sectional view taken along line VIII-VIII' of FIG. 6.
FIG. 9 is a cross-sectional view taken along line IX-IX' of FIG. 7.
FIG. 10A is a plan view illustrating an emission layer and an opposite electrode of FIG. 8.
FIG. 10B is a plan view illustrating an emission layer and an opposite electrode of FIG. 9.
FIG. 11 is a plan view illustrating a portion of a first display area of a display device according to an embodiment.
FIG. 12 is a plan view illustrating a portion of a second display area of a display device according to an embodiment.
FIG. 13 is a plan view illustrating a portion of a first display area of a display device according to an embodiment. and
FIG. 14 is a plan view illustrating a portion of a second display area of a display device according to an embodiment.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Throughout the disclosure, the expression "at least one of a, b or c" indicates only a, only b, only c, both a and b, both a and c, both b and c, all of a, b, and c, or variations thereof.

In the following description, for the purposes of explanation, numerous specific details are set forth in order to provide a thorough understanding of various embodiments or implementations of the invention. As used herein "embodiments" and "implementations" are interchangeable words that are non-limiting examples of devices or methods employing one or more of the inventive concepts disclosed herein. It is apparent, however, that various embodiments may be practiced without these specific details or with one or more equivalent arrangements. In other instances, well-known structures and devices are shown in block diagram form in order to avoid unnecessarily obscuring various embodiments. Further, various embodiments may be different, but do not have to be exclusive. For example, specific shapes, configurations, and characteristics of an embodiment may be used or implemented in another embodiment without departing from the inventive concepts.

Unless otherwise specified, the illustrated embodiments are to be understood as providing features of varying detail of some ways in which the inventive concepts may be implemented in practice. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the inventive concepts.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the D1-axis, the D2-axis, and the D3-axis are not limited to three axes of a rectangular coordinate system, such as the x, y, and z - axes, and may be interpreted in a broader sense. For example, the D1-axis, the D2-axis, and the D3-axis may be perpendicular to one another, or may represent different directions that are not perpendicular to one another. For the purposes of this disclosure, "at least one of X, Y, and Z" and "at least one selected from the group consisting of X, Y, and Z" may be construed as X only, Y only, Z only, or any combination of two or more of X, Y, and Z, such as, for instance, XYZ, XYY, YZ, and ZZ. As used herein, the term "and/or" includes any and all combinations of one or more of the associated listed items.

Although the terms "first," "second," etc. may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one elements relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various embodiments are described herein with reference to sectional and/or exploded illustrations that are schematic illustrations of embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

Unless otherwise defined, all terms (including technical and scientific terms) used herein have the same meaning as commonly understood by one of ordinary skill in the art to which this disclosure is a part. Terms, such as those defined in commonly used dictionaries, should be interpreted as having a meaning that is consistent with their meaning in the context of the relevant art and should not be interpreted in an idealized or overly formal sense, unless expressly so defined herein.

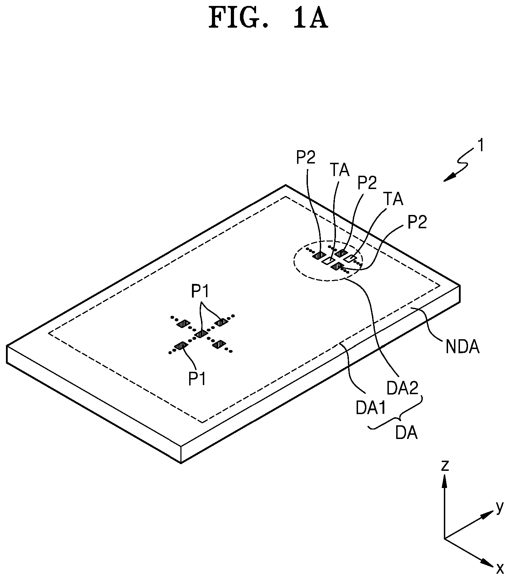

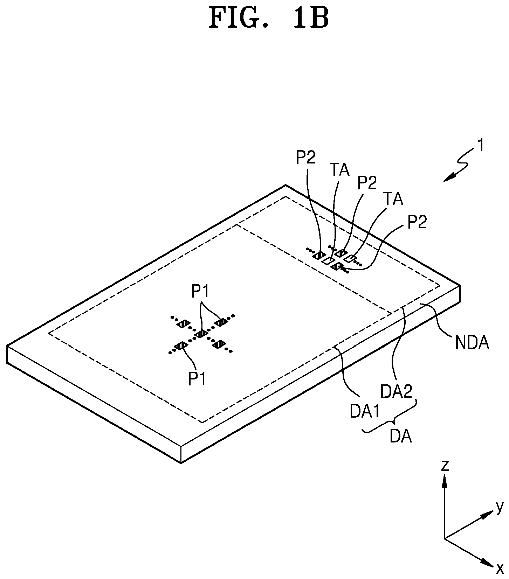

FIGS. 1A and 1B are perspective views illustrating an electronic apparatus 1 including a display device according to an embodiment.

Referring to FIGS. 1A and 1B, the electronic apparatus 1 may include a display area DA and a non-display area NDA, the non-display area NDA being outside the display area DA. The electronic apparatus 1 may provide an image through an array of a plurality of pixels arranged two-dimensionally. The plurality of pixels may include first pixels P1 arranged in a first display area DA1, and second pixels P2 arranged in a second display area DA2.

The electronic apparatus 1 may provide a first image by using light emitted from the first pixels P1 arranged in the first display area DA1, and provide a second image by using light emitted from the second pixels P2 arranged in the second display area DA2. In an embodiment, the first image and the second image may include portions of one of images displayed by the display area DA of the electronic apparatus 1. In an embodiment, the electronic apparatus 1 may provide the first image and the second image independent of each other.

The second display area DA2 includes a transmission area TA located between the second pixels P2. The transmission area TA includes a region through which light may pass and in which a pixel is not arranged.

The non-display area NDA includes a region that does not display an image and may entirely surround the display area DA. A driver, etc. may be arranged in the non-display area NDA, the driver providing an electric signal or power to the first pixels P1 and the second pixels P2. The non-display area NDA may include a pad to which an electronic element or a printed circuit board, etc. may be electrically connected.

As illustrated in FIG. 1A, the second display area DA2 may have a circular or elliptical shape in a plan view. Alternatively, the second display area DA2 may have a polygonal shape such as a quadrangular or bar type as illustrated in FIG. 1B.

The second display area DA2 may be arranged inside the first display area DA1 (see FIG. 1A) or arranged on one side of the first display area DA1 (see FIG. 1B). As illustrated in FIG. 1A, the second display area DA2 may be entirely surrounded by the first display area DA1. In an embodiment, the second display area DA2 may be partially surrounded by the first display area DA1. For example, the second display area DA2 may be located in a corner portion on one side of the first display area DA1 and partially surrounded by the first display area DA1.

A ratio of the second display area DA2 to the display area DA may be less than a ratio of the first display area DA1 to the display area DA. As illustrated in FIG. 1A, the electronic apparatus 1 may include one second display area DA2 or include two or more second display areas DA2.

The electronic apparatus 1 may include mobile phones, tablet personal computers (PC), notebook computers, and smartwatches or smartbands worn on a wrist.

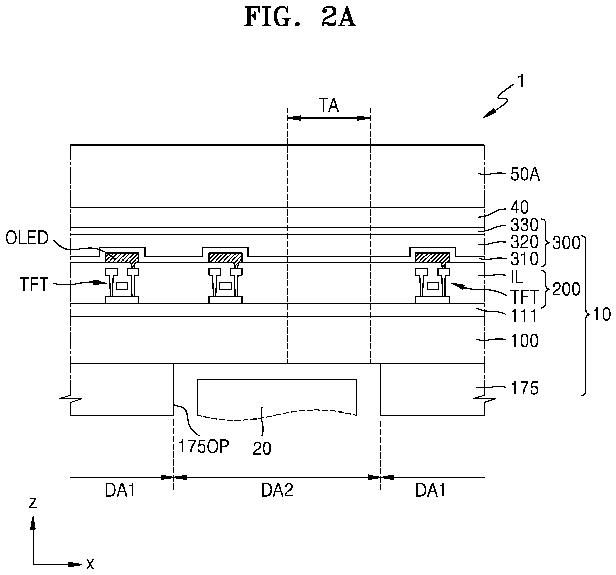

FIGS. 2A to 2C are cross-sectional views of a portion of the electronic apparatus 1 including a display device according to an embodiment.

Referring to FIGS. 2A to 2C, the electronic apparatus 1 includes a display device 10 and a component 20 overlapping the display device 10.

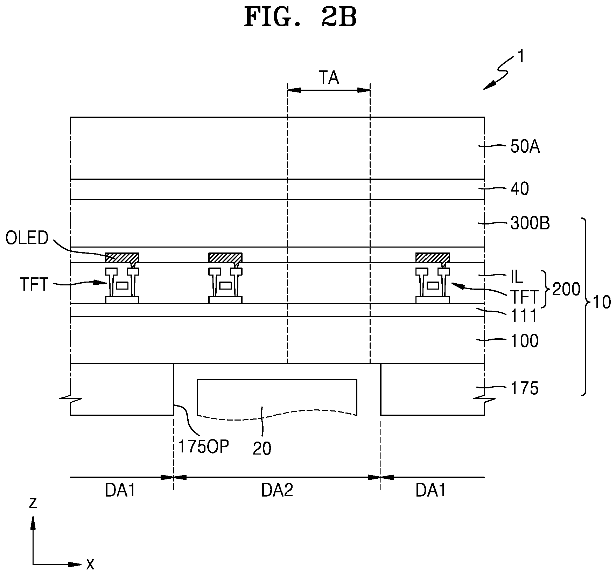

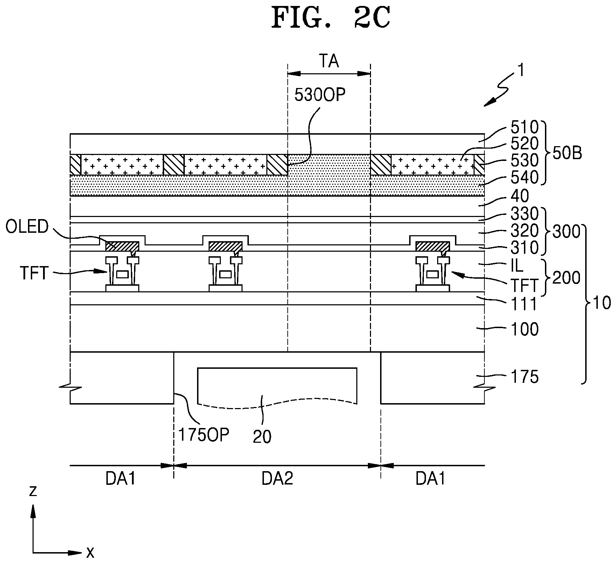

The display device 10 may include a substrate 100, a display layer 200, a thin-film encapsulation layer 300, a touch input layer 40, and an optical functional layer such as an optical plate 50A (see FIGS. 2A and 2B) or a filter plate 50B (see FIG. 2C), the display layer 200 being on the substrate 100, and the thin-film encapsulation layer 300 being on the display layer 200.

The substrate 100 may include glass or a polymer resin. For example, the polymer resin of the substrate 100 may include polyethersulfone, polyacrylate, polyetherimide, polyethylene naphthalate, polyethylene terephthalate, polyphenylene sulfide, polyarylate, polyimide, polycarbonate, and cellulose acetate propionate. The substrate 100 including the polymer resin may be flexible, rollable, or bendable. The substrate 100 may have a multi-layered structure including a layer including the polymer resin and an inorganic layer (not illustrated).

The display layer 200 may be arranged on a front surface of the substrate 100, and a bottom protective film 175 may be arranged on a rear surface of the substrate 100. The bottom protective film 175 may be attached on the rear surface of the substrate 100. An adhesive layer (not illustrated) may be arranged between the bottom protective film 175 and the substrate 100. Alternatively, the bottom protective film 175 may be directly formed on the rear surface of the substrate 100. In such case, the adhesive layer may not be arranged between the bottom protective film 175 and the substrate 100.

The bottom protective film 175 may support and protect the substrate 100. The bottom protective film 175 may include an opening 175OP overlapping the second display area DA2. Because the bottom protective film 175 includes the opening 175OP, a transmittance of the second display area DA2, for example, a light transmittance of the transmission area TA may be improved. The bottom protective film 175 may include polyethylene terephthalate (PET) or polyimide (PI).

The display layer 200 may include a circuit layer, a display element layer, and an insulating layer IL, the circuit layer including a thin film transistor TFT, and the display element layer including an organic light-emitting diode OLED, which is a display element. A thin film transistor TFT and an organic light-emitting diode OLED may be arranged in each of the first display area DA1 and the second display area DA2, the organic light-emitting diode OLED being electrically connected to the thin film transistor TFT. The second display area DA2 may include the transmission area TA in which the thin film transistor TFT and the organic light-emitting diode OLED are not arranged.

The transmission area TA includes a region through which light emitted from the component 20 and/or directed to the component 20 may pass. In the display device 10, a transmittance of the transmission area TA may be 30% or more, 40% or more, 50% or more, 60% or more, 75% or more, 80% or more, 85% or more, or 90% or more. The transmission area TA may lay between two thin film transistor TFT structures.

The display layer 200 may be covered by the thin-film encapsulation layer 300 or covered by an encapsulation substrate 300B.

In an embodiment, as illustrated in FIGS. 2A and 2C, the thin-film encapsulation layer 300 may include at least one inorganic encapsulation layer and at least one organic encapsulation layer. In an embodiment, the thin-film encapsulation layer 300 may include first and second inorganic encapsulation layers 310 and 330 and an organic encapsulation layer 320 therebetween.

In an embodiment, as illustrated in FIG. 2B, the encapsulation substrate 300B may face the substrate 100 with the display layer 200 therebetween. There may be a gap between the encapsulation substrate 300B and the display layer 200. The encapsulation substrate 300B may include glass. Sealant is arranged between the substrate 100 and the encapsulation substrate 300B. The sealant is arranged in the non-display area NDA described with reference to FIG. 1A or 1B. The sealant arranged in the non-display area NDA surrounds the display area DA and prevents moisture from penetrating to the display area DA through a lateral side thereof.

The touch input layer 40 may obtain an external input, for example, and coordinate information corresponding to a touch event. The touch input layer 40 may include a touch electrode and trace lines, the trace lines being connected to the touch electrode. The touch input layer 40 may sense an external input by using a mutual capacitive method or a self-capacitive method.

The touch input layer 40 may be formed on the thin-film encapsulation layer 300. Alternatively, the touch input layer 40 may be formed separately and then coupled on the thin-film encapsulation layer 300 through an adhesive layer such as an optical clear adhesive OCA. In an embodiment, as illustrated in FIGS. 2A to 2C, the touch input layer 40 may be directly formed right on the thin-film encapsulation layer 300. In this case, the adhesive layer may not be arranged between the touch input layer 40 and the thin-film encapsulation layer 300.

The optical function layer (optical plate 50A or filter plate 50B) may include a reflection prevention layer. The reflection prevention layer may reduce reflectivity of light (external light) incident toward the display device 10 from the outside.

In an embodiment, as illustrated in FIG. 2A or 2B, the reflection prevention layer may include the optical plate 50A including a retarder and/or a polarizer. The retarder may include a film-type retarder or a liquid crystal-type retarder. The retarder may include a λ/2 retarder and/or a λ/4 retarder. The polarizer may include a film-type polarizer or a liquid crystal-type polarizer. The film-type polarizer may include a stretchable synthetic resin film, and the liquid crystal-type polarizer may include liquid crystals arranged in a predetermined arrangement.

In an embodiment, as illustrated in FIG. 2C, the reflection prevention layer may include the filter plate 50B including a black matrix and color filters. The filter plate 50B may include a base layer 510, color filters 520, a black matrix 530, and an overcoat layer 540. The color filters 520 and the black matrix 530 may be disposed on a rear surface of the base layer 510, and the overcoat layer 540 may be on the color filters 520 and the black matrix 530.

The color filters 520 may be arranged by taking into account colors of light emitted from pixels of the display device 10. For example, the color filter 520 may have red, green, or blue color depending on the color of light emitted from an organic light-emitting diode OLED. There is no color filter 520 and no black matrix 530 in the transmission area TA. For example, a layer including the color filter 520 and the black matrix 530 may include a hole 530OP corresponding to the transmission area TA. The hole 530OP may be positioned between two thin film transistors TFT in a plan view. The hole 530OP may be positioned between two organic light-emitting diodes OLEDs in a plan view. The hole 530OP may be at least partially filled with a portion of the overcoat layer 540. The overcoat layer 540 may include an organic material such as a resin. The organic material may be transparent. A structure of the filter plate 50B is applicable to the display device 10 including the encapsulation substrate 300B illustrated in FIG. 2B.

In an embodiment, the reflection prevention layer may include a destructive interference structure. The destructive interference structure may include a first reflective layer and a second reflective layer arranged on different layers. First-reflected light and second-reflected light respectively reflected by the first reflective layer and the second reflective layer may be destructively interfered and thus reflectivity of external light may be reduced.

The component 20 may be located in the second display area DA2. The component 20 may include an electronic element that uses light or sound. For example, the electronic element may include a sensor measuring a distance such as a proximity sensor, a sensor recognizing a portion (e.g. a fingerprint, an iris, a face, etc.) of a user's body, a small lamp outputting light, or an image sensor (e.g. a camera) capturing an image. The electronic element that uses light may use light in various wavelength bands such as visible light, infrared light, and ultraviolet light. The electronic element that uses sound may use an ultrasonic wave or sound in other frequency bands.

In an embodiment, the component 20 may include sub-components such as a light emitter and a light receiver. The light emitter and the light receiver may have an integrated structure, or a pair of light emitter and light receiver that have physically separated structures may constitute one component 20.

One component 20 may be arranged in the second display area DA2 or a plurality of components 20 may be arranged in the second display area DA2. In the case where the electronic apparatus 1 includes a plurality of components 20, the electronic apparatus 1 may include the number of second display areas DA2 corresponding to the number of components 20. For example, the electronic apparatus 1 may include a plurality of second display areas DA2 described with reference to FIG. 1A. The plurality of second display areas DA2 may be apart from each other. In an embodiment, in the case where the electronic apparatus 1 includes a plurality of components 20, the electronic apparatus 1 may include one second display area DA2. For example, the electronic apparatus 1 may include the second display area DA2 described with reference to FIG. 1B. The plurality of components 20 may be apart from each other in a lengthwise direction (e.g. an x-direction of FIG. 1) of the second display area DA2 of a bar type.

Though it is illustrated in FIGS. 2A to 2C that the display device 20 includes the organic light-emitting diode OLED as a display element, the display device 10 according to the embodiment is not limited thereto. In another embodiment, the display device 10 may include inorganic light-emitting displays including an inorganic material, or quantum dot light-emitting displays, the inorganic material including micro light-emitting diodes. For example, an emission layer of a display element of the display device 10 may include an organic material, include an inorganic material, include a quantum dot, include an organic material and a quantum dot, or include an inorganic material and a quantum dot.

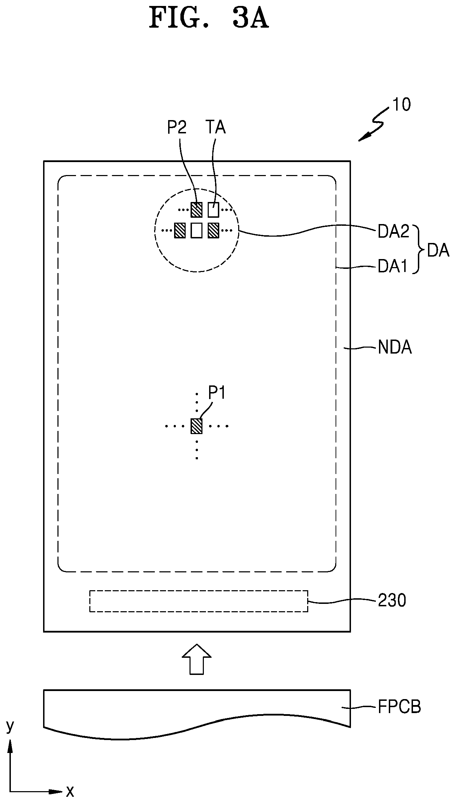

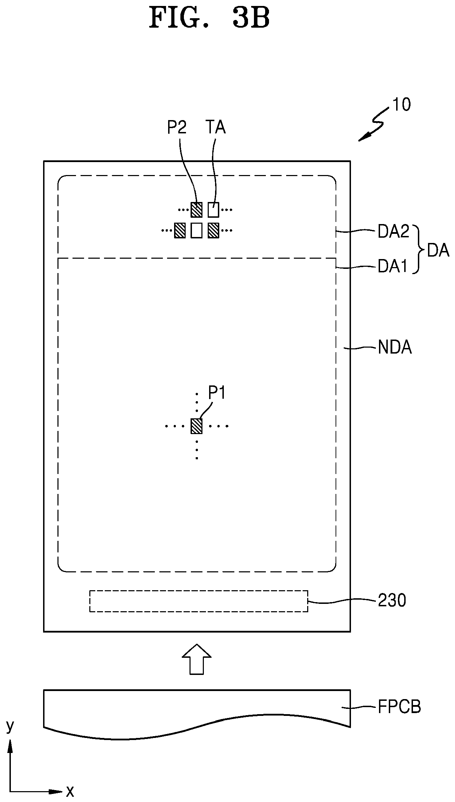

FIGS. 3A and 3B are plan views of the display device 10 according to an embodiment.

Referring to FIGS. 3A and 3B, the display device 10 includes an array of a plurality of pixels arranged on the substrate 100. The plurality of pixels includes the first pixels P1 arranged in the first display area DA1 and the second pixels P2 arranged in the second display area DA2.

The display area DA includes the first display area DA1 and the second display area DA2. An area of the first display area DA1 may be different from an area of the second display area DA2. The area of the first display area DA1 may be greater than the area of the second display area DA2.

The first pixels P1 may be two-dimensionally arranged in the first display area DA1 and the second pixels P2 may be two-dimensionally arranged in the second display area DA2. The transmission area TA is arranged in the second display area DA2. The transmission area TA may be arranged between second pixels P2 that are close to each other.

The non-display area NDA may entirely surround the display area DA. A scan driver, a data driver, etc. may be arranged in the non-display area NDA. A pad 230 may be located in the non-display area NDA. The pad 230 may be adjacent one of the edges of the substrate 100. The pad 230 may be exposed by not being covered by an insulating layer and be electrically connected to a flexible printed circuit board FPCB. The flexible printed circuit board FPCB may electrically connect a controller to the pad 230 and supply a signal or power transferred from the controller. In an embodiment, a data driver may be arranged on the flexible printed circuit board FPCB. To transfer a signal or voltage of the flexible printed circuit board FPCB to the first pixels P1 or the second pixels P2, the pad 230 may be connected to a plurality of wirings.

In another embodiment, instead of the flexible printed circuit board FPCB, an integrated circuit may be arranged on the pad 230. The integrated circuit may include, for example, a data driver and may be electrically connected to the pad 230 through an anisotropic conductive film including a conductive ball.

Each of the first pixel P1 and the second pixel P2 may emit light having a predetermined color by using the organic light-emitting diode OLED (see FIGS. 2A to 2C). Each organic light-emitting diode OLED may emit, for example, red, green, or blue light. Each organic light-emitting diode OLED may be connected to a pixel circuit including a transistor and a capacitor.

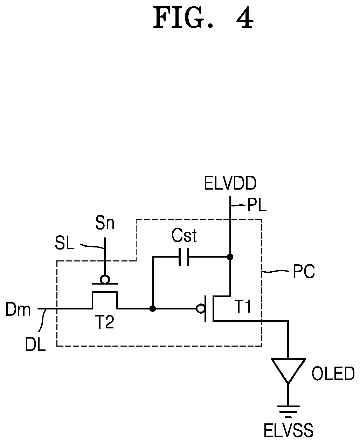

FIG. 4 is an equivalent circuit diagram illustrating a circuit connected to an organic light-emitting diode OLED of the display device 10 according to an embodiment.

Referring to FIG. 4, the organic light-emitting diode OLED is electrically connected to a pixel circuit PC. The pixel circuit PC may include a first thin film transistor T1, a second thin film transistor T2, and a storage capacitor Cst.

The second thin film transistor T2 is a switching thin film transistor, may be connected to a scan line SL and a data line DL, and may transfer a data voltage (or a data signal Dm) input from a data line DL to the first thin film transistor T1 based on a switching voltage (or a switching signal Sn) input from the scan line SL. A storage capacitor Cst may be connected to a second thin film transistor T2 and a driving voltage line PL and may store a voltage corresponding to a difference between a voltage transferred from the second thin film transistor T2 and a first power voltage ELVDD supplied to the driving voltage line PL.

The first thin film transistor T1 is a driving thin film transistor, may be connected to the driving voltage line PL and the storage capacitor Cst, and may control a driving current flowing through an organic light-emitting diode OLED from the driving voltage line PL in response to the voltage stored in the storage capacitor Cst. The organic light-emitting diode OLED may emit light having a predetermined brightness by using the driving current. An opposite electrode (e.g. a cathode) of the organic light-emitting diode OLED may receive a second power voltage ELVSS.

Though it is illustrated in FIG. 4 that a pixel circuit PC includes two thin film transistors and one storage capacitor, the embodiment is not limited thereto. The number of thin film transistors and the number of storage capacitors may be variously changed depending on a design of the pixel circuit PC. For example, the pixel circuit PC may include three, four, five or more thin film transistors.

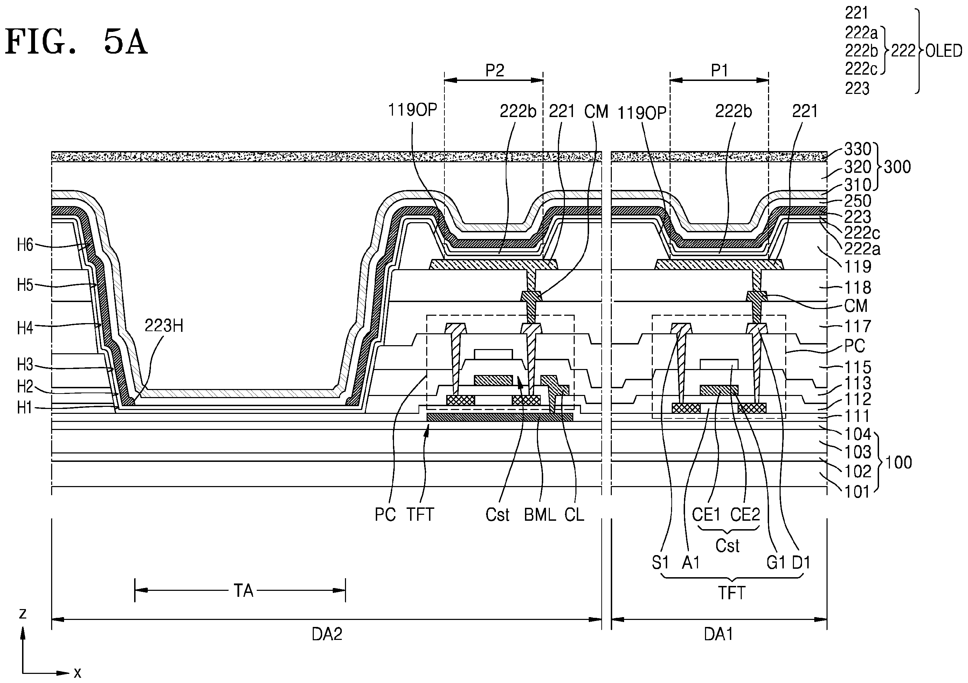

FIG. 5A is a cross-sectional view illustrating a portion of the display device 10 according to an embodiment. FIG. 5A illustrates one portions of the first display area DA1 and the second display area DA2.

Referring to FIG. 5A, the substrate 100 may have a multi-layered structure. The substrate 100 may include a first base layer 101, a first inorganic layer 102, a second base layer 103, and a second inorganic layer 104 that are sequentially stacked.

Each of the first base layer 101 and the second base layer 103 may include a polymer resin. The polymer resin may include polyethersulfone (PES), polyacrylate (PAR), polyetherimide (PEI), polyethylene naphthalate (PEN), polyethylene terephthalate (PET), polyphenylene sulfide (PPS), polyimide (PI), polycarbonate, cellulose tri acetate (TAC), and cellulose acetate propionate (CAP). The polymer resin may be transparent.

Each of the first inorganic layer 102 and the second inorganic layer 104 includes a barrier layer preventing the penetration of external foreign substances and may include a single layer or a multi-layer including an inorganic material such as silicon nitride, silicon oxynitride, and/or silicon oxide.

A buffer layer 111 may reduce or block the penetration of foreign substances, moisture, or external air from below the substrate 100 and provide a flat surface on the substrate 100. The buffer layer 111 may include an inorganic insulating material such as silicon oxide, silicon oxynitride, and silicon nitride and have a single-layered structure or a multi-layered structure including the above materials.

The pixel circuit PC may be arranged on the buffer layer 111, the pixel circuit PC including the thin film transistor TFT and the storage capacitor Cst. The pixel circuit PC may be arranged in the first display area DA1 and the second display area DA2. The pixel circuit PC of the first display area DA1 may have the same structure as that of the pixel circuit PC of the second display area DA2. A bottom metal layer BML may be arranged between the pixel circuit PC and the substrate 100 that are arranged in the second display area DA2. In the second display area DA2, the bottom metal layer BML may prevent light from being diffracted through a narrow gap between wirings connected to the pixel circuit PC and may improve the performance of a thin film transistor TFT, the light being emitted from or directed to the component 20 described with reference to FIGS. 2A to 2C. There is no bottom metal layer BML in the transmission area TA. For example, the bottom metal layer BML may include a hole(s) located in the transmission area TA.

The bottom metal layer BML may be electrically connected to a connection line CL. The connection line CL may be electrically connected to a line connected to the pixel circuit PC, the storage capacitor Cst, or the thin film transistor TFT. For example, the bottom metal layer BML may be electrically connected to a gate electrode, a source electrode, or a drain electrode of a thin film transistor TFT, or may be electrically connected to the driving voltage line PL (see FIG. 4) described above with reference to FIG. 4 or one of the capacitor plates of the storage capacitor Cst.

The thin film transistor TFT may include a semiconductor layer A1, a gate electrode G1, a source electrode S1, and a drain electrode D1, the gate electrode G1 overlapping a channel region of the semiconductor layer A1, and the source electrode S1 and the drain electrode D1 being respectively connected to a source region and a drain region of the semiconductor layer A1. A gate insulating layer 112 may be arranged between the semiconductor layer A1 and the gate electrode G1. A first interlayer insulating layer 113 and a second interlayer insulating layer 115 may be arranged between the gate electrode G1 and the source electrode S1, or between the gate electrode G1 and the drain electrode D1.

The storage capacitor Cst may overlap the thin film transistor TFT. The storage capacitor Cst may include a first capacitor plate CE1 and a second capacitor plate CE2 overlapping each other. In an embodiment, the gate electrode G1 of the thin film transistor TFT may include the first capacitor plate CE1 of the storage capacitor Cst. The first interlayer insulating layer 113 may be arranged between the first capacitor plate CE1 and the second capacitor plate CE2.

The semiconductor layer A1 may include polycrystalline silicon. In an embodiment, the semiconductor layer A1 may include amorphous silicon. In an embodiment, the semiconductor layer A1 may include an oxide of at least one of indium (In), gallium (Ga), tin (Sn), zirconium (Zr), vanadium (V), hafnium (Hf), cadmium (Cd), germanium (Ge), chromium (Cr), titanium (Ti), and zinc (Zn). The semiconductor layer A1 may include a channel region, a source region, and a drain region, the source region and the drain region being doped with impurities.

The gate insulating layer 112 may include an inorganic insulating material such as silicon oxide, silicon oxynitride, and silicon nitride and have a single-layered structure or a multi-layered structure including the above materials.

The gate electrode G1 or the first capacitor plate CE1 may include a low-resistance conductive material such as molybdenum (Mo), aluminium (Al), copper (Cu), and/or titanium (Ti) and have a single-layered structure or a multi-layered structure including the above materials.

The first interlayer insulating layer 113 may include an inorganic insulating material such as silicon oxide, silicon oxynitride, and silicon nitride and have a single-layered structure or a multi-layered structure including the above materials.

The second capacitor plate CE2 may include aluminium (Al), platinum (Pt), palladium (Pd), silver (Ag), magnesium (Mg), gold (Au), nickel (Ni), neodymium (Nd), iridium (Ir), chromium (Cr), lithium (Li), calcium (Ca), molybdenum (Mo), titanium (Ti), tungsten (W), and/or copper (Cu) and have a single-layered structure or a multi-layered structure including the above materials.

The second interlayer insulating layer 115 may include an inorganic insulating material such as silicon oxide, silicon oxynitride, and silicon nitride and have a single-layered structure or a multi-layered structure including the above materials.

The source electrode S1 or the drain electrode D1 includes aluminium (Al), platinum (Pt), palladium (Pd), silver (Ag), magnesium (Mg), gold (Au), nickel (Ni), neodymium (Nd), iridium (Ir), chromium (Cr), calcium (Ca), molybdenum (Mo), titanium (Ti), tungsten (W), and/or copper (Cu) and have a single-layered structure or a multi-layered structure including the above materials. For example, the source electrode S1 or the drain electrode D1 may have a three-layered structure of a titanium layer/aluminium layer/titanium layer.

The pixel circuit PC may be electrically connected to a pixel electrode 221, the pixel circuit PC including the thin film transistor TFT and the storage capacitor Cst. In an embodiment, as illustrated in FIG. 5A, the pixel circuit PC may be electrically connected to the pixel electrode 221 by a contact metal CM.

The contact metal CM may be arranged on a first planarization layer 117 and connected to the pixel circuit PC through a contact hole formed in the first planarization layer 117. The contact metal CM may include aluminium (Al), platinum (Pt), palladium (Pd), silver (Ag), magnesium (Mg), gold (Au), nickel (Ni), neodymium (Nd), iridium (Ir), chromium (Cr), calcium (Ca), molybdenum (Mo), titanium (Ti), tungsten (W), and/or copper (Cu) and have a single-layered structure or a multi-layered structure including the above materials.

The first planarization insulating layer 117 may include an organic insulating material. The first planarization insulating layer 117 may include an organic insulating material such as acryl, benzocyclobutene (BCB), polyimide, or hexamethyldisiloxane (HMDSO). The organic insulating material of the first planarization insulating layer 117 may include a photosensitive organic insulating material.

A second planarization insulating layer 118 is arranged on the contact metal CM. The second planarization insulating layer 118 may include an organic insulating material. The second planarization insulating layer 118 may include an organic insulating material such as acryl, benzocyclobutene (BCB), polyimide, or hexamethyldisiloxane (HMDSO). The organic insulating material of the second planarization insulating layer 118 may include a photosensitive organic insulating material.

The pixel electrode 221 may be arranged on the second planarization insulating layer 118. The pixel electrode 221 may be connected to the contact metal CM through a contact hole of the second planarization insulating layer 118.

The pixel electrode 221 may include a reflective layer including silver (Ag), magnesium (Mg), aluminium (Al), platinum (Pt), palladium (Pd), gold (Au), nickel (Ni), neodymium (Nd), iridium (Ir), chromium (Cr), or a compound thereof. The pixel electrode 221 may include a reflective layer including the above material and a transparent conductive layer on and/or under the reflective layer. The transparent conductive layer may include indium tin oxide (ITO), indium zinc oxide (IZO), zinc oxide (ZnO), indium oxide (In₂O₃), indium gallium oxide (IGO), or aluminium zinc oxide (AZO). In an embodiment, the pixel electrode 221 may have a three-layered structure of an ITO layer/Ag layer/ITO layer that are sequentially stacked.

A pixel-defining layer 119 may be arranged on the pixel electrode 221. The pixel-defining layer 119 may cover the edges of the pixel electrode 221 and include an opening 119OP overlapping a central portion of the pixel electrode 221.

The pixel-defining layer 119 may include an organic insulating material such as polyimide, polyamide, an acrylic resin, a benzocyclobutene, hexamethyldisiloxane (HMDSO), and a phenolic resin.

An intermediate layer 222 includes an emission layer 222b overlapping the pixel electrode 221. The emission layer 222b may include an organic material. The emission layer 222b may include a polymer organic material or a low molecular weight organic material emitting light having a predetermined color.

A first function layer 222a and a second functional layer 222c may be respectively arranged under and on the emission layer 222b.

The first functional layer 222a may include a single layer or a multi-layer. For example, in the case where the first functional layer 222a includes a polymer material, the first functional layer 222a may include a hole transport layer (HTL), which has a single-layered structure, and include poly(3,4-ethylenedioxythiophene) (PEDOT) or polyaniline (PANI). In the case where the first functional layer 222a includes a low molecular weight material, the first functional layer 222a may include a hole injection layer (HIL) and a hole transport layer (HTL).

The second functional layer 222c may be omitted. For example, in the case where the first functional layer 222a and the emission layer 222b include a polymer material, it may be preferable that the second functional layer 222c is formed. The second functional layer 222c may include a single layer or a multi-layer. The second functional layer 222c may include an electronic transport layer (ETL) and/or an electron injection layer (EIL).

Each of the first functional layer 222a and the second functional layer 222c may entirely cover the display area, for example, the first display area DA1 and the second display area DA2.

An opposite electrode 223 may include a conductive material having a relatively small work function. For example, the opposite electrode 223 may include a (semi) transparent layer including silver (Ag), magnesium (Mg), aluminium (Al), nickel (Ni), chromium (Cr), lithium (Li), calcium (Ca), or an alloy thereof. Alternatively, the opposite electrode 223 may further include a layer including ITO, IZO, ZnO, or In₂O₃ on the (semi) transparent layer including the above material. In an embodiment, the opposite electrode 223 may include silver (Ag) and magnesium (Mg).

A stacked structure of the pixel electrode 221, the intermediate layer 222, and the opposite electrode 223 that are sequentially stacked may constitute a light-emitting diode, for example, an organic light-emitting diode OLED. The organic light-emitting diode OLED may emit red, green, or blue light. An emission area of each organic light-emitting diode OLED corresponds to a pixel. For example, the first pixel P1 corresponds to an emission area of an organic light-emitting diode OLED arranged in the first display area DA1, and the second pixel P2 corresponds to an emission area of an organic light-emitting diode OLED arranged in the second display area DA2. Because the opening 119OP of the pixel-defining layer 119 defines a size and/or a width of an emission area, sizes and/or widths of the first pixel P1 and the second pixel P2 may depend on the opening 119OP of the pixel-defining layer 119 corresponding thereto.

The organic light-emitting diode OLED may be covered by the thin-film encapsulation layer 300. The thin-film encapsulation layer 300 may include the first and second inorganic encapsulation layers 310 and 330 and the organic encapsulation layer 320 therebetween.

The first and second inorganic encapsulation layers 310 and 330 may include one or more inorganic insulating materials. The inorganic insulating material may include aluminium oxide, titanium oxide, tantalum oxide, hafnium oxide, zinc oxide, silicon oxide, silicon nitride, and/or silicon oxynitride. The first and second inorganic encapsulation layers 310 and 330 may be formed by chemical vapor deposition.

The organic encapsulation layer 320 may include a polymer-based material. The polymer-based material may include an acryl-based resin, an epoxy-based resin, polyimide, and polyethylene. For example, the organic encapsulation layer 320 may include an acrylic resin, for example, polymethylmethacrylate, poly acrylic acid, etc. The organic encapsulation layer 320 may be formed by hardening a monomer or coating a polymer.

Referring to the transmission area TA of FIG. 5A, insulating layers on the substrate 100 may respectively include holes formed in the transmission area TA. For example, as illustrated in FIG. 5A, the gate insulating layer 112, the first interlayer insulating layer 113, the second interlayer insulating layer 115, the first planarization layer 117, the second planarization layer 118, and the pixel-defining layer 119 each may be located in the transmission area TA and may respectively include first to sixth holes H1, H2, H3, H4, H5, and H6.

The first functional layer 222a and the second functional layer 222c may cover the transmission area TA. In contrast, the opposite electrode 223 may include a hole 223H formed in the transmission area TA to improve a transmittance of the transmission area TA.

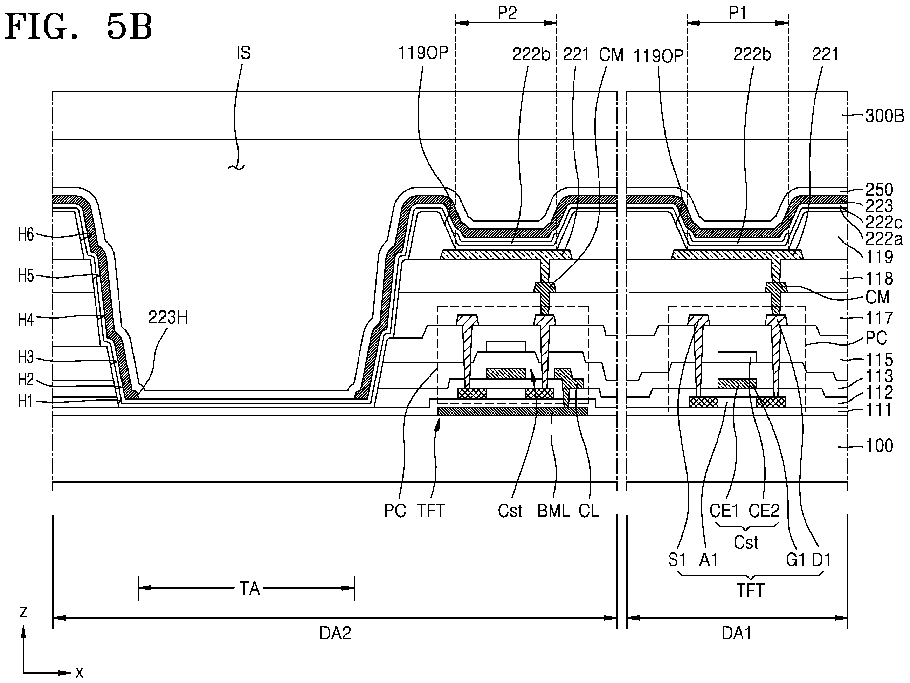

FIG. 5B is a cross-sectional view illustrating a portion of the display device 10 according to an embodiment.

FIG. 5B illustrates that the display device has substantially the same structure described with reference to FIG. 5A and that the substrate 100 has a single-layered structure and the encapsulation substrate 300B is arranged instead of the thin-film encapsulation layer 300.

The substrate 100 may include a glass material and the encapsulation substrate 300B may include a glass material. Each of the substrate 100 and the encapsulation substrate 300B may include a glass substrate. An inner space IS may be defined between the substrate 100 and the encapsulation substrate 300B. There may be an air layer in the inner space IS. Alternatively, there may be a transparent material layer in the inner space IS. The transparent material layer may include a transparent material having a refractive index similar to refractive indexes of the substrate 100 and the encapsulation substrate 300B. The transparent material may include a liquid transparent material. The transparent material may include epoxy, urethane acrylate, epoxy acrylate or a silicon-based resin (e.g. bisphenol A type epoxy, a cycloaliphatic epoxy resin, a phenyl silicone resin or rubber, an acrylic epoxy resin, aliphatic urethane acrylate, etc.). Alternatively, for the transparent material, silicon or silicon oils with no phase change in the temperature range of about -40°C to about 100°C and a volume change rate within about 5% may be used, the silicon or silicon oils including hexamethyldisiloxane, octamethyltrisiloxane, decamethyltetrasiloxane, dodecamethylpentasiloxane, and polydimethylsiloxanes.

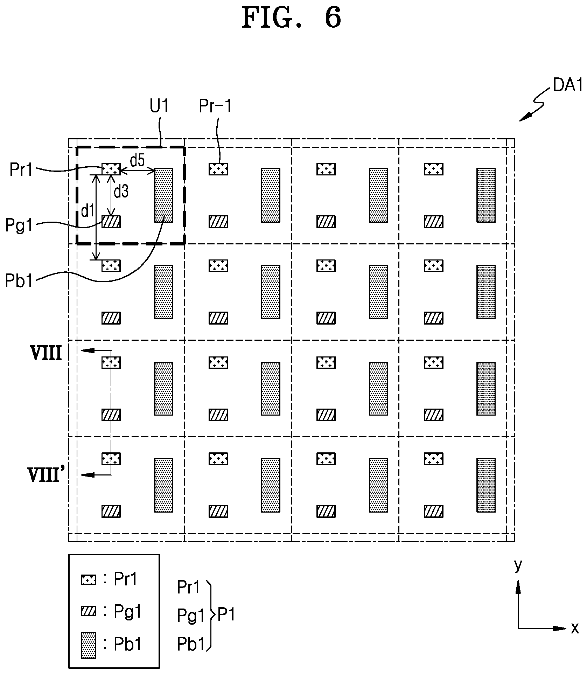

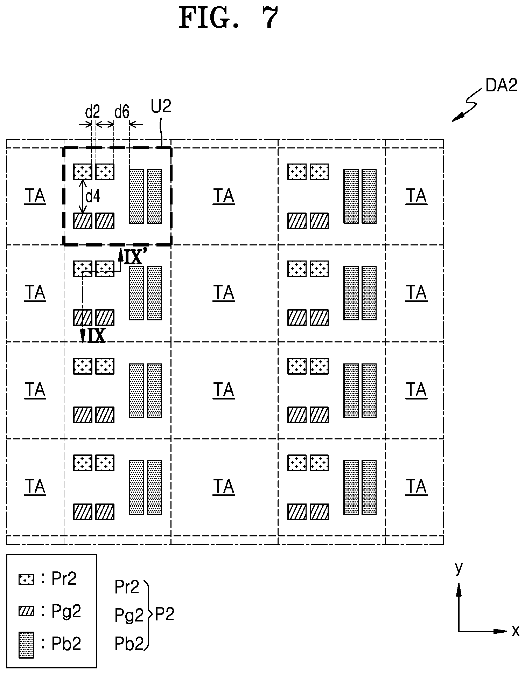

FIG. 6 is a plan view illustrating a portion of the first display area DA1 of the display device 10 according to an embodiment, and FIG. 7 is a plan view illustrating a portion of the second display area DA2 of the display device 10 according to an embodiment.

Referring to FIG. 6, the first pixels P1 are arranged in the first display area DA1. The first pixels P1 include a first red pixel Pr1, a first green pixel Pg1, and a first blue pixel Pb1. A structure of each of the first red pixel Pr1, the first green pixel Pg1, and the first blue pixel Pb1 may correspond to a cross-sectional structure of the first pixel P1 described above with reference to FIGS. 5A and 5B.

An array of the first pixels P1 arranged in the first display area DA1 may include an arrangement structure of first pixel units U1. For example, the first pixel unit U1 corresponds to a minimal repeating unit. The minimal repeating unit is a repeating unit having a smallest number of pixels. For example, as illustrated in FIG. 6, a block including one first red pixel Pr1, one first green pixel Pg1, and one first blue pixel Pb1 may correspond to the first pixel unit U1.

Referring to FIG. 7, the second pixels P2 are arranged in the second display area DA2. The second pixels P2 include a second red pixel Pr2, a second green pixel Pg2, and a second blue pixel Pb2. A structure of each of the second red pixel Pr2, the second green pixel Pg2, and the second blue pixel Pb2 may correspond to a cross-sectional structure of the second pixel P2 described above with reference to FIGS. 5A and 5B.

An array of the second pixels P2 arranged in the second display area DA2 may include an arrangement structure of a plurality of second pixel units U2. For example, the second pixel unit U2 corresponds to a minimal repeating unit. The minimal repeating unit is a repeating unit having a smallest number of pixels. For example, as illustrated in FIG. 7, a block including two second red pixels Pr2, two second green pixels Pg2, and two second blue pixels Pb2 may correspond to the second pixel unit U2.

The second display area DA2 includes the transmission area TA between the second pixel units U2. The transmission area TA corresponds to a region in which a pixel is not arranged, that is, a region in which a second pixel unit(s) U2 is not arranged.

In the claimed invention, the number of pixels included in the second pixel unit U2 may be twice or more than the number of pixels included in the first pixel unit U1. For example, as illustrated in FIGS. 6 and 7, the number of pixels included in the second pixel unit U2 may be six, and the number of pixels included in the first pixel unit U1 may be three.

Pixels emitting light having the same color among the second pixels P2 included in the second pixel unit U2, for example, the second red pixel Pr2, the second green pixel Pg2, and the third blue pixel Pb2 may be arranged to neighbor each other. In the present specification, when pixels are referred to as being arranged to neighbor each other, they may be arranged close to each other, of varying distances. In the present specification, pixels may be separated from each other by various distances. As illustrated in FIG. 7, second red pixels Pr2 may neighbor each other at a second distance d2, second green pixels Pg2 may neighbor each other at the second distance d2, and second blue pixels Pb2 may neighbor each other at the second distance d2.

A distance between neighboring pixels having the same color in the second display area DA2 may be less than a distance between neighboring pixels having the same color in the first display area DA1. For example, as illustrated in FIG. 7, the second distance d2 between second red pixels Pr2 neighboring each other in the second display area DA2 may be less than a first distance d1 between first red pixels Pr1 neighboring each other in the first display area DA1 as illustrated in FIG. 6. Similarly, the second distance d2 between second green pixels Pg2 neighboring each other in the second display area DA2 may be less than the first distance d1 between first green pixels Pg1 adjacent each other in the first display area DA1. The second distance d2 between second blue pixels Pb2 neighboring each other in the second display area DA2 may be less than the first distance d1 between first blue pixels Pb1 adjacent each other in the first display area DA1.

The first distance d1 may correspond to a distance between same color pixels of adjacent two pixel units, such as illustrated in FIG. 6. The second distance d2 may correspond to distances between same color pixels in pixel unit, such as illustrated in FIG. 7.

A distance between pixels having different colors in the second display area DA2 may be equal to or less than pixels having different colors in the first display area DA1. For example, as illustrated in FIG. 7, a fourth distance d4 between a second red pixel Pr2 and a second green pixel Pg2 in the second display area DA2 may be less than a third distance d3 between a first red pixel Pr1 and a first green pixel Pg1 in the first display area DA1. Alternatively, the fourth distance d4 may be equal to the third distance d3.

Similarly, a sixth distance d6 between a second red pixel Pr2 and a second blue pixel Pb2 in the second display area DA2 may be less than a fifth distance d5 between a first red pixel Pr1 and a first blue pixel Pb1 in the first display area DA1. Alternatively, the sixth distance d6 may be equal to the fifth distance d5.

A size or a shape of the first pixel P1 may be different from a size or a shape of the second pixel P2. In an embodiment, it is illustrated that a size of the first pixel P1, for example, sizes of the first red pixel Pr1, the first green pixel Pg1, and the first blue pixel Pb1 are different from respective sizes of the second red pixel Pr2, the second green pixel Pg2, and the second blue pixel Pb2. For example, as illustrated in FIGS. 6 and 7, a size of the first pixel P1 may be greater than a size of the second pixel P2. Though it is illustrated in FIGS. 6 and 7 that the first pixel P1 and the second pixel P2 have a quadrangular shape, the shapes thereof may be variously changed. The shape of the first pixel P1 or the second pixel P2 may be variously changed to a diamond shape, a circular shape, or an elliptical shape. In this case, the shape of the first pixel P1 may be different from the shape of the second pixel P2.

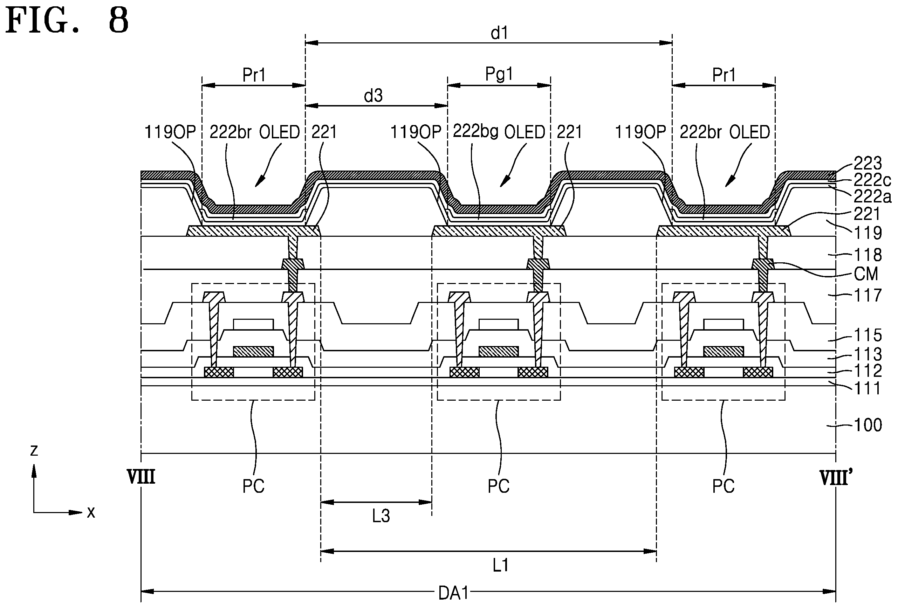

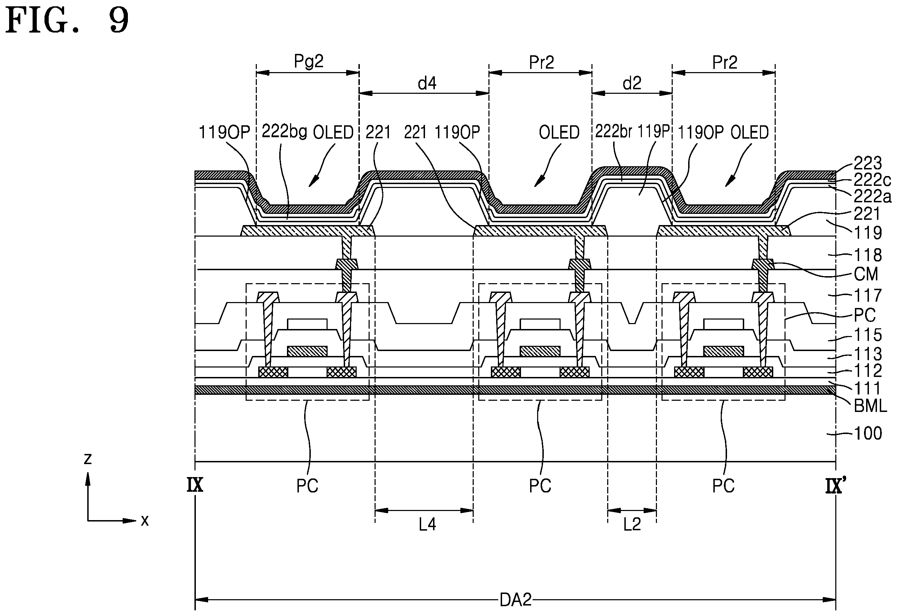

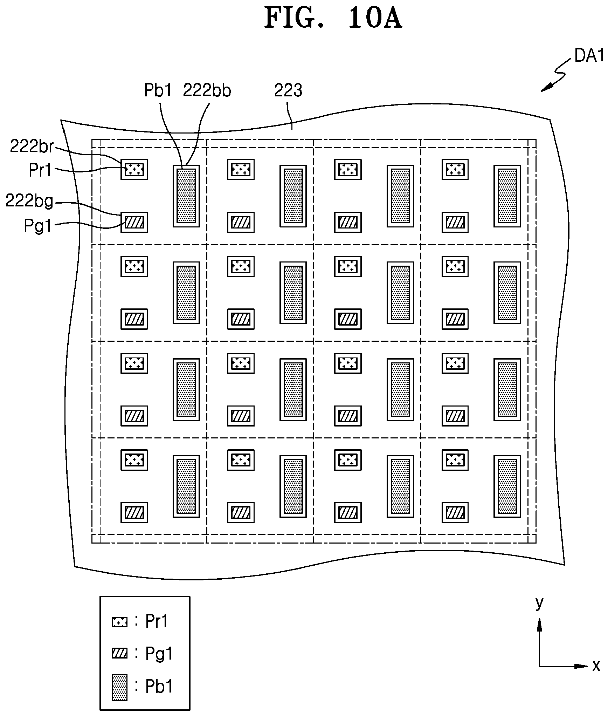

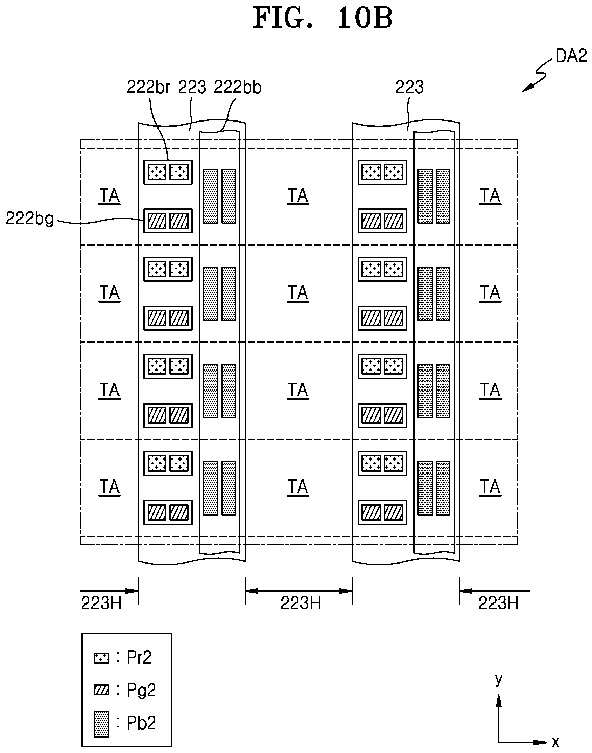

FIG. 8 is a cross-sectional view illustrating the first display area DA1 taken along line VIII-VIII' of FIG. 6, FIG. 9 is a cross-sectional view illustrating the second display area DA2 taken along line IX-IX' of FIG. 7, FIG. 10A is a plan view illustrating the emission layer and the opposite electrode of FIG. 8, and FIG. 10B is a plan view illustrating the emission layer and the opposite electrode of FIG. 9.

Referring to FIGS. 8 and 9, pixel circuits PC are arranged on the substrate 100, and each of the pixel circuits PC is electrically connected to an organic light-emitting diode OLED arranged on the pixel circuit PC. A structure of insulating layers arranged on the pixel circuit PC, the organic light-emitting diode OLED, and the substrate 100 is substantially the same as that described above with reference to FIG. 5A. As illustrated in FIG. 9, the bottom metal layer BML may be arranged in the second display area DA2. The bottom metal layer BML may correspond to at least one pixel circuit PC. For example, as illustrated in FIG 9, a plurality of pixel circuits PC may overlap the bottom metal layer BML.

A pixel may correspond to an emission area of light emitted from the organic light-emitting diode OLED. As illustrated in FIGS. 8 and 9, the emission area of the organic light-emitting diode OLED may be defined by an opening 119OP of the pixel-defining layer 119, and thus a distance between pixels is substantially the same as a distance between the openings 119OP of the pixel-defining layer 119 corresponding to the relevant pixel.

The first distance d1 between first red pixels Pr1 neighboring each other in the first display area DA1 of FIG. 8 may be greater than the second distance d2 between second red pixels Pr2 neighboring each other in the second display area DA2 of FIG. 9. Similarly, a first separation distance L1 between the pixel electrodes 221 corresponding to the first red pixels Pr1 neighboring each other in the first display area DA1 may be greater than a second separation distance L2 between the pixel electrodes 221 corresponding to the second red pixels Pr2 neighboring each other in the second display area DA2. The first separation distance L1 may be less than the first distance d1, and the second separation distance L2 may be less than the second distance d2.

A third distance d3 between the first red pixel Pr1 and the first green pixel Pg1 neighboring each other in the first display area DA1 of FIG. 8 may be equal to or greater than the fourth distance d4 between the second red pixel Pr2 and the second green pixel Pg2 neighboring each other in the second display area DA2 of FIG. 9. Similarly, a third separation distance L3 between the pixel electrodes 221 corresponding to the first red pixel Pr1 and the first green pixel Pg1 neighboring each other in the first display area DA1 may be equal to or greater than a fourth separation distance L4 between the pixel electrodes 221 corresponding to the second red pixel Pr2 and the second green pixel Pg2 neighboring each other in the second display area DA2. The third separation distance L3 may be less than the third distance d3, and the fourth separation distance L4 may be less than the fourth distance d4.

A pixel having a different color may be arranged between pixels having the same color and neighboring each other in the first display area DA1. For example, as illustrated in FIGS. 6 and 8, the first green pixel Pg1 may be arranged between the first red pixels Pr1 neighboring each other. Therefore, one emission layer may correspond to each pixel in the first display area DA1.

For example, as illustrated in FIGS. 8 and 10A, a red emission layer 222br may correspond to one first red pixel Pr1. Likewise, a green emission layer 222bg may correspond to one first green pixel Pg1, and a blue emission layer 222bb may correspond to one first blue pixel Pb1.

Unlike the red emission layer 222br, the green emission layer 222bg, and the blue emission layer 222bb each corresponding to one pixel, the opposite electrode 223 may be formed as one body to cover a plurality of pixels.

Alternatively, a pixel having a different color may not be arranged between pixels having the same color neighboring each other in the second display area DA2. Referring to FIGS. 7 and 9, a different pixel is not arranged between second red pixels Pr2 neighboring each other in a second pixel unit U2 (see FIG. 7). Therefore, one emission layer may correspond to a plurality of pixels in the second display area DA2.

For example, as illustrated in FIGS. 9 and 10B, the red emission layer 222br may correspond to two second red pixels Pr2. The red emission layer 222br may cover a top surface of a portion 119P of the pixel-defining layer 119 located between the openings 119OP defining the two second red pixels Pr2. Similarly, as illustrated in FIG. 10B, the green emission layer 222bg may correspond to two second green pixels Pg2, and the blue emission layer 222bb may correspond to two second blue pixels Pb2 in the x-direction. Alternatively, as illustrated in FIG. 10B, the blue emission layer 222bb may be formed as one body to correspond to second blue pixels Pb2 of two columns arranged in an x-direction and y-direction.

As illustrated in FIG. 10B, the opposite electrode 223 does not cover a region corresponding to the transmission area TA. With regard to this, it is illustrated in FIG. 10B that the opposite electrode 223 includes a hole 223H located in the transmission area TA.

The hole 223H of the opposite electrode 223 may be formed as follows. The hole 223H of the opposite electrode 223 may be formed by forming the opposite electrode 223 to entirely cover the first display area DA1 and the second display area DA2, and then removing a region corresponding to the hole 223H. The region corresponding to the hole 223H may be removed by using a laser, etc. Alternatively, the opposite electrode 223 may be deposited by using a mask including a shield portion arranged in the region corresponding to the hole 223H. Because a region of the mask that is around the shield portion is an opening, the opposite electrode 223 may be deposited in the first display area DA1 and a portion of the second display area DA2 while a deposition material passes through the opening of the mask. Because the transmission area TA is shielded by the shield portion during a deposition process, the hole 223 may be formed in the transmission area TA.

During the deposition process, an issue may occur in which the deposition material is accumulated in a region of an object (e.g. the substrate ranging from the buffer layer to the intermediate layer) on which the deposition material is deposited, by a shadow phenomenon, the region corresponding to the shield portion of the mask. The above issue may be related to a transmittance of the transmission area TA and an area of the transmission area TA. Because the second display area DA2 includes the transmission area TA, the holes 223H of the opposite electrodes 223 should be arranged between pixels. As the number of holes 223H increases, the shadow phenomenon may occur more. A small number of pixels may be arranged in the second display area DA2 to secure a sufficient transmission area TA while taking into account the shadow phenomenon. In this case, the resolution of the second display area DA2 may be reduced.

However, according to the embodiments, as described above with reference to FIGS. 6 to 10B, because the second pixel unit U2 includes a greater number of pixels than the first pixel unit U1, the reduction of the resolution may be minimized in the second display area.

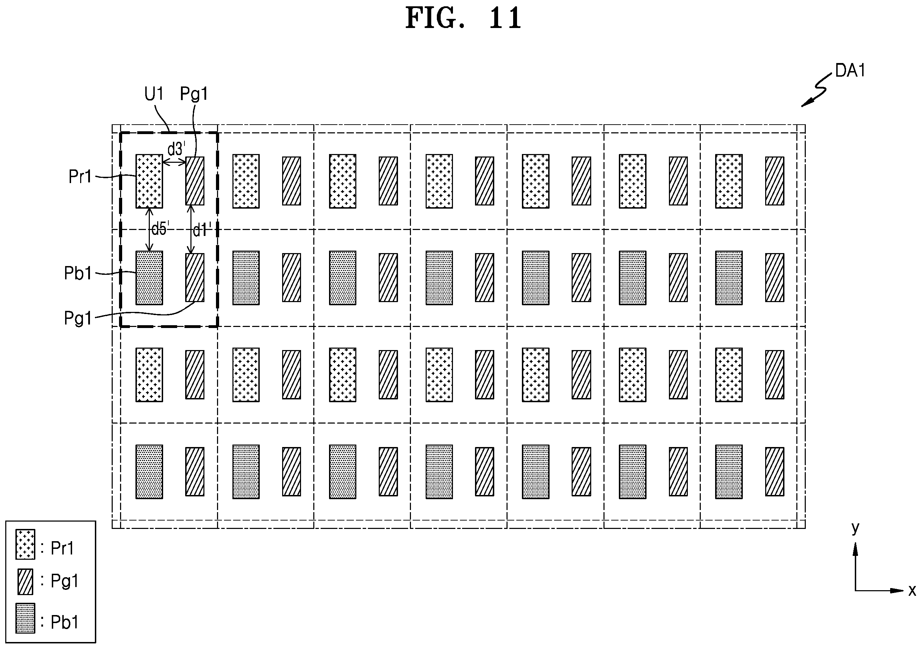

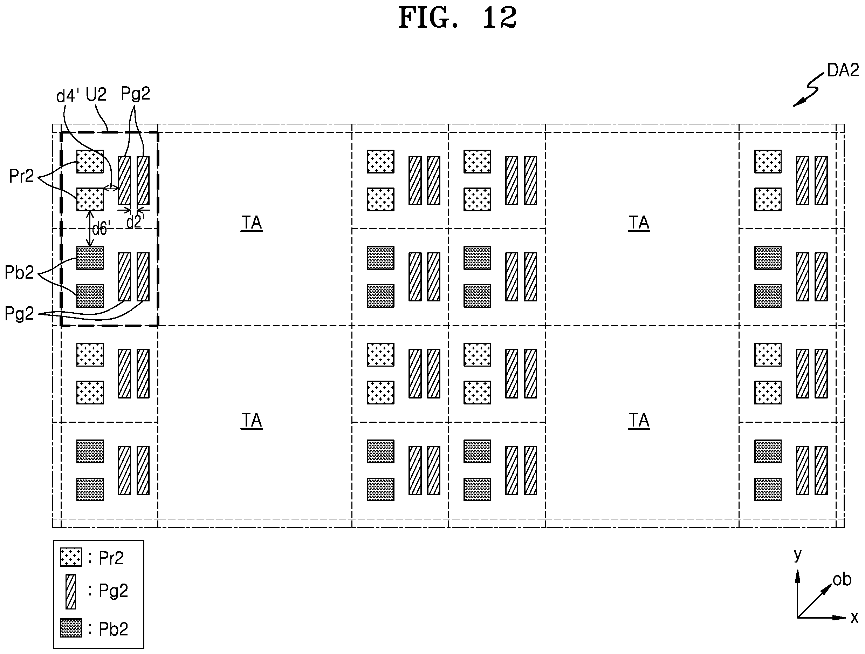

FIG. 11 is a plan view illustrating a portion of the first display area DA1 of the display device according to an embodiment, and FIG. 12 is a plan view illustrating a portion of the second display area DA2 of the display device according to an embodiment. Referring to FIGS. 11 and 12, it is illustrated that pixels are arranged in a pentile configuration, for example, a stripe pentile type (or stripe pentile configuration).

Referring to FIG. 11, the first pixel unit U1 of the first display area DA1 may include four pixels. For example, the first pixel unit U1 may include one first red pixel Pr1, two first green pixels Pg1, and one first blue pixel Pb1.

Referring to FIG. 12, the second pixel unit U2 of the second display area DA2 includes a greater number of pixels than the number of pixels included in the first pixel unit U1. For example, as illustrated in FIG. 12, the second pixel unit U2 may include eight pixels including two second red pixels Pr2, four second green pixels Pg2, and two second blue pixels Pb2.

Pixels emitting the same color among the second pixels included in the second pixel unit U2, for example, the second red pixels Pr2, the second green pixels Pg2, and the second blue pixels Pb2 may neighbor each other. As illustrated in FIG. 12, two second red pixels Pr2 may neighbor each other, and two second green pixels Pg2 may neighbor each other. Other two second green pixels Pg2 may neighbor each other, and two second blue pixels Pb2 may neighbor each other. Though it is illustrated in FIG. 12 that two second green pixels Pg2 and other two second green pixels Pg2 neighbor each other in the y-direction, two second green pixels Pg2 and other two second green pixels Pg2 in the second pixel unit U2 may be arranged in an oblique direction (e.g. a diagonal direction ob) with respect to the x-direction and the y-direction in another embodiment.

A distance between pixels having the same color and neighboring each other in the second display area DA2 may be less than a distance between pixels having the same color and neighboring each other in the first display area DA1. For example, as illustrated in FIG. 12, a second distance d2' between second green pixels Pg2 neighboring each other in the second display area DA2 may be less than a first distance d1' between first green pixels Pg1 neighboring each other in the first display area DA1 as illustrated in FIG. 11. Similarly, a distance between second red pixels Pr2 neighboring each other in the second display area DA2 may be less than a distance between first red pixels Pr1 neighboring each other in the first display area DA1. A distance between second blue pixels Pb2 neighboring each other in the second display area DA2 may be less than a distance between first blue pixels Pb1 neighboring each other in the first display area DA1.

A distance between pixels having different colors and neighboring each other in the second display area DA2 may be equal to or less than a distance between pixels having different colors and neighboring each other in the first display area DA1. For example, as illustrated in FIG. 12, a fourth distance d4' between a second red pixel Pr2 and a second green pixel Pg2 neighboring each other in the second display area DA2 may be less than a third distance d3' between a first red pixel Pr1 and a first green pixel Pg1 neighboring each other in the first display area DA1. Alternatively, the fourth distance d4' may be equal to the third distance d3'.

Similarly, a sixth distance d6' between a second red pixel Pr2 and a second blue pixel Pg2 neighboring each other in the second display area DA2 may be less than a fifth distance d5' between a first red pixel Pr1 and a first blue pixel Pb1 neighboring each other in the first display area DA1. Alternatively, the sixth distance d6' may be equal to the fifth distance d5'.

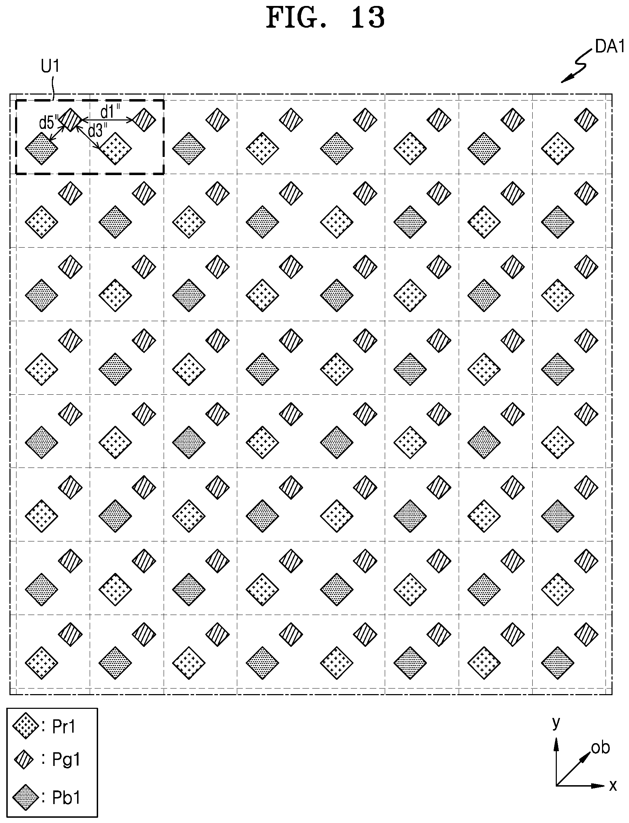

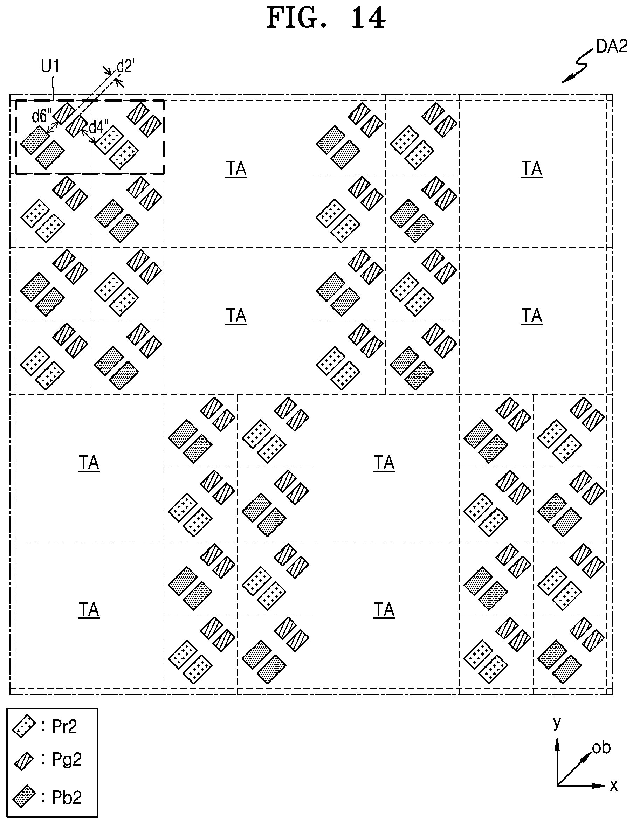

FIG. 13 is a plan view illustrating a portion of the first display area DA1 of the display device according to an embodiment, and FIG. 14 is a plan view illustrating a portion of the second display area DA2 of the display device according to an embodiment. FIGS. 13 and 14 illustrate that pixels are arranged in a pentile type, for example, a diamond pentile type.

Referring to FIG. 13, a first pixel unit U1 of the first display area DA1 may include four pixels. For example, the first pixel unit U1 may include one first red pixel Pr1, two first green pixels Pg1, and one first blue pixel Pb1. The one first red pixel Pr1 and the one first green pixel Pg1 may be arranged in a direction (e.g. a diagonal direction) oblique with respect to the x-direction and the y-direction, and the first blue pixel Pb1 and another first green pixel Pg1 may be arranged in a direction (e.g. a diagonal direction) with respect to the x-direction and the y-direction.

Referring to FIG. 14, the second pixel unit U2 of the second display area DA2 includes a greater number of pixels than the number of pixels included in the first pixel unit U1. For example, as illustrated in FIG. 14, the second pixel unit U2 may include two second red pixels Pr2, four second green pixels Pg2, and two second blue pixels Pb2.

Pixels emitting light of the same color among the second pixels P2 included the second pixel unit U2, for example, the second red pixels Pr2, the second green pixels Pg2, and the second blue pixels Pb2 may be arranged to neighbor each other. As illustrated in FIG. 14, two second red pixels Pr2 may neighbor each other, and two second green pixels Pg2 may neighbor each other. Other two second green pixels Pg2 may neighbor each other, and other two second blue pixels Pb2 may neighbor each other. Two second red pixels Pr2 and two second green pixels Pg2 may be arranged in a direction (e.g. a diagonal direction ob) oblique with respect to the x-direction and the y-direction, and two second blue pixels Pb2 and other two second green pixels Pg2 may be arranged in a direction (e.g. a diagonal direction ob) oblique with respect to the x-direction and the y-direction.

A distance between pixels having the same color and neighboring each other in the second display area DA2 may be less than a distance between pixels having the same color and neighboring each other in the first display area DA1. For example, as illustrated in FIG. 14, a second distance d2" between second green pixels Pg2 neighboring each other in the second display area DA2 may be less than a first distance d1" between first green pixels Pg1 neighboring each other in the first display area DA1 as illustrated in FIG. 13. Similarly, a distance between second red pixels Pr2 neighboring each other in the second display area DA2 may be less than a distance between first red pixels Pr1 neighboring each other in the first display area DA1. A distance between second blue pixels Pb2 neighboring each other in the second display area DA2 may be less than a distance between first blue pixels Pb1 neighboring each other in the first display area DA1.

A distance between pixels having different colors and neighboring each other in the second display area DA2 may be equal to or less than a distance between pixels having different colors and neighboring each other in the first display area DA1. For example, as shown in FIG. 14, a fourth distance d4" between a second red pixel Pr2 and a second green pixel Pg2 neighboring each other in the second display area DA2 may be less than a third distance d3" between a first red pixel Pr1 and a first green pixel Pg1 neighboring each other in the first display area DA1. Alternatively, the fourth distance d4" may be equal to the third distance d3".

Similarly, a sixth distance d6" between a second green pixel Pg2 and a second blue pixel Pb2 neighboring each other in the second display area DA2 may be less than a fifth distance d5" between a first green pixel Pg1 and a first blue pixel Pb1 neighboring each other in the first display area DA1. Alternatively, the sixth distance d6" may be equal to the fifth distance d5".

The second display area DA2 may include the transmission area TA, and some of the transmission areas TA may neighbor each other in the x-direction and the y-direction. Other transmission areas TA may neighbor each other and be arranged in a direction oblique with respect to the x-direction and the y-direction. The arrangement of the transmission area TA is equally applicable to the second display area DA2 described with reference to FIGS. 12 or 7.

Embodiments may provide a display device and an electronic apparatus in which a component such as a sensor or a camera may be arranged while securing a wide area of a display area displaying an image. Embodiments may also provide a display device and an electronic apparatus that may prevent resolution reduction while securing a sufficient transmission area for the component. These effects are provided as examples and the scope of the inventive concepts is not limited by these effects.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A display device (10) including a display area (DA) and a non-display area (NDA) surrounding the display area (DA), the display area (DA) including a first display area (DA1) and a second display area (DA2), the display device (10) comprising:
a substrate (100); and
a plurality of pixels arranged over the substrate (100) and including first pixels (P1) and second pixels (P2), the first pixels (P1) included in the first display area (DA1), and the second pixels (P2) included in the second display area (DA2),
wherein the first pixels (P1) include a repeating arrangement structure of first pixel units (U1) each including a plurality of pixels having different colors, and the second pixels (P2) include a repeating arrangement structure of second pixel units (U2) each including a plurality of pixels having different colors and each including a greater number of pixels than the number of pixels included in each of the first pixel units (U1),
the first pixel units (U1) each include at least one first red pixel (Pr1), at least one first green pixel (Pg1), and at least one first blue pixel (Pb1),
the second pixel units (U2) each include at least one second red pixel (Pr2), at least one second green pixel (Pg2), and at least one second blue pixel (Pb2),
the second display area (DA2) includes a transmission area (TA) between the second pixel units (U2) that are repeatedly arranged,
a first distance (d1) between pixels of the same color that neighbor each other among the first pixels (P1) is greater than a second distance (d2) between pixels of the same color that neighbor each other among the second pixels (P2), and
**characterized in that** the sum of the number of the at least one second red pixel (Pr2), the number of the at least one second green pixel (Pg2), and the number of the at least one second blue pixel (Pb2) is twice or more of the sum of the number of the at least one first red pixel (Pr1), the number of the at least one first green pixel (Pg1), and the number of the at least one first blue pixel (Pb1).

2. The display device (10) according to claim 1, wherein a third distance (d3) between pixels of different colors that neighbor each other among the first pixels (P1) is equal to or greater than a fourth distance (d4) between pixels of different colors that neighbor each other among the second pixels (P2).

3. The display device (10) according to claim 1 or claim 2, wherein:
(i) a size or a shape of the first pixels (P1) is different from a size or a shape of the second pixels (P2); and/or
(ii) a pixel of a different color is arranged between pixels of the same color that neighbor each other among the first pixels (P1).

4. The display device (10) according to any one of claims 1 to 3, wherein the second pixel units (P2) each include at least two pixels of the same color.

5. The display device (10) according to any one of claims 1 to 4, further comprising a plurality of light-emitting diodes (OLED) respectively corresponding to the first pixels (P1) and the second pixels (P2),
wherein each of the plurality of light-emitting diodes (OLED) has a stacked structure of a pixel electrode (221), an emission layer (222b), and an opposite electrode (223).

6. The display device (10) according to claim 5, wherein a first separation distance (L1) between pixel electrodes (221) respectively corresponding to pixels having the same color that neighbor each other among the first pixels (P1) is greater than a second separation distance (L2) between pixel electrodes (221) respectively corresponding to pixels having the same color that neighbor each other among the second pixels (P2).

7. The display device (10) according to claim 5 or claim 6, wherein:
(i) the emission layers (222b) respectively corresponding to pixels of the same color that neighbor each other among the second pixels (P2) are formed as a single body; and/or
(ii) the opposite electrodes (223) respectively corresponding to the first pixels (P1) and the second pixels (P2) are formed as a single body and include a hole (223H) corresponding to the transmission area (TA).

8. The display device (10) according to any one of claims 1 to 7, further comprising a bottom metal layer (BML) arranged between the substrate (100) and the plurality of pixels and located in the second display area (DA2).

9. An electronic apparatus (1) comprising:
a display device (10) including a first display area (DA1) and a second display area (DA2); and
a component (20) overlapping a transmission area (TA) of the second display area (DA2),
wherein the display device (10) includes a plurality of pixels including first pixels (P1) in the first display area (DA1) and second pixels (P2) in the second display area (DA2),
the first pixels (P1) include a repeating arrangement structure of first pixel units (U1) each including a plurality of pixels having different colors, the second pixels (P2) include a repeating arrangement structure of a second pixel units (U2) each including a plurality of pixels having different colors and each including a greater number of pixels than the number of pixels included in each of the first pixel units (U1),
the first pixel units (U1) each include at least one first red pixel (Pr1), at least one first green pixel (Pg1), and at least one first blue pixel (Pb1),
the second pixel units (U2) each include at least one second red pixel (Pr2), at least one second green pixel (Pg2), and at least one second blue pixel (Pb2),
the transmission area (TA) is between the second pixel units (U2) that are repeatedly arranged,
a first distance (d1) between pixels of the same color that neighbor each other among the first pixels (P1) is greater than a second distance (d2) between pixels of the same color that neighbor each other among the second pixels (P2), and
**characterized in that** the sum of the number of the at least one second red pixel (Pr2), the number of the at least one second green pixel (Pg2), and the number of the at least one second blue pixel (Pb2) is twice or more of the sum of the number of the at least one first red pixel (Pr1), the number of the at least one first green pixel (Pg1), and the number of the at least one first blue pixel (Pb1).

10. The electronic apparatus (1) according to claim 9, wherein:
(i) a third distance (d3) between pixels of different colors that neighbor each other among the first pixels (P1) is equal to or greater than a fourth distance (d4) between pixels of different colors that neighbor each other among the second pixels (P2); and/or
(iii) a size or a shape of the first pixels (P1) is different from a size or a shape of the second pixels (P2).

11. The electronic apparatus (1) according to claim 9 or 10, further comprising:
a plurality of light-emitting diodes (OLED) respectively corresponding to the first pixels (P1) and the second pixels (P2); and
a plurality of thin-film transistors (TFT) respectively connected to the plurality of light-emitting diodes (OLED),
wherein each of the plurality of light-emitting diodes (OLED) has a stacked structure of a pixel electrode (221), an emission layer (222b), and an opposite electrode (223), optionally wherein the electronic apparatus (1) further comprises a bottom metal layer (BML) arranged below thin-film transistors (TFT) located in the second display area (DA2) among the plurality of thin-film transistors (TFT).

12. The electronic apparatus (1) according to claim 11, wherein a first separation distance (L1) between pixel electrodes (221) respectively corresponding to pixels of the same color that neighbor each other among the first pixels (P1) is greater than a second separation distance (L2) between pixel electrodes (221) respectively corresponding to pixels of the same color that neighbor each other among the second pixels (P2).

13. The electronic apparatus (1) according to claim 11 or claim 12, wherein the emission layers (222b) respectively corresponding to pixels of the same color that neighbor each other among the second pixels (P2) are formed as a single body, optionally wherein the single body of the emission layers covers a top surface of a pixel-defining layer (119), the pixel-defining layer (119) covering edges of pixel electrodes (221) respectively corresponding to pixels of the same color that neighbor each other among the second pixels (P2).

14. The electronic apparatus (1) according to any one of claims 9 to 13, wherein:
(i) a pixel of a different color is located between pixels of the same color that neighbor each other among the first pixels (P1); and/or
(ii) the component (20) includes a sensor or a camera.

## Patentansprüche

1. Anzeigevorrichtung (10), die einen Anzeigebereich (DA) und einen Nicht-Anzeigebereich (NDA) einschließt, der den Anzeigebereich (DA) umgibt, wobei der Anzeigebereich (DA) einen ersten Anzeigebereich (DA1) und einen zweiten Anzeigebereich (DA2) einschließt, die Anzeigevorrichtung (10) umfassend:
ein Substrat (100); und
eine Vielzahl von Pixeln, die über dem Substrat (100) angeordnet ist und erste Pixel (P1) und zweite Pixel (P2) einschließt, wobei die ersten Pixel (P1) in dem ersten Anzeigebereich (DA1) eingeschlossen sind und die zweiten Pixel (P2) in dem zweiten Anzeigebereich (DA2) eingeschlossen sind,
wobei die ersten Pixel (P1) eine sich wiederholende Anordnungsstruktur von ersten Pixeleinheiten (U1) einschließen, die jeweils eine Vielzahl von Pixeln einschließen, die unterschiedlichen Farben aufweisen, und die zweiten Pixel (P2) eine sich wiederholende Anordnungsstruktur von zweiten Pixeleinheiten (U2) einschließen, die jeweils eine Vielzahl von Pixeln einschließen, die unterschiedlichen Farben aufweisen, und jeweils eine größere Anzahl von Pixeln einschließen als die Anzahl der Pixel, die in jeder der ersten Pixeleinheiten (U1) eingeschlossen sind,
die ersten Pixeleinheiten (U1) jeweils mindestens ein erstes rotes Pixel (Pr1), mindestens ein erstes grünes Pixel (Pg1) und mindestens ein erstes blaues Pixel (Pb1) einschließen,
die zweiten Pixeleinheiten (U2) jeweils mindestens ein zweites rotes Pixel (Pr2), mindestens ein zweites grünes Pixel (Pg2) und mindestens ein zweites blaues Pixel (Pb2) einschließen,
der zweite Anzeigebereich (DA2) einen Transmissionsbereich (TA) zwischen den wiederholt angeordneten zweiten Pixeleinheiten (U2) einschließt,
einen ersten Abstand (d1) zwischen Pixeln derselben Farbe, die zueinander benachbart in den ersten Pixeln (P1) sind, größer ist als ein zweiter Abstand (d2) zwischen Pixeln derselben Farbe, die zueinander benachbart in den zweiten Pixeln (P2) sind, und
**dadurch gekennzeichnet, dass** die Summe der Anzahl des mindestens einen zweiten roten Pixels (Pr2), der Anzahl des mindestens einen zweiten grünen Pixels (Pg2) und der Anzahl des mindestens einen zweiten blauen Pixels (Pb2) zweimal oder mehr der Summe der Anzahl des mindestens einen ersten roten Pixels (Pr1), der Anzahl des mindestens einen ersten grünen Pixels (Pg1) und der Anzahl des mindestens einen ersten blauen Pixels (Pb1) beträgt.

2. Anzeigevorrichtung (10) nach Anspruch 1, wobei ein dritter Abstand (d3) zwischen zueinander benachbarten Pixeln unterschiedlicher Farbe unter den ersten Pixeln (P1) gleich oder größer ist als ein vierter Abstand (d4) zwischen zueinander benachbarten Pixeln unterschiedlicher Farbe unter den zweiten Pixeln (P2).

3. Anzeigevorrichtung (10) nach Anspruch 1 oder Anspruch 2, wobei:
(i) sich eine Größe oder eine Form der ersten Pixel (P1) von einer Größe oder einer Form der zweiten Pixel (P2) unterscheidet; und/oder
(ii) ein Pixel einer anderen Farbe zwischen Pixeln derselben Farbe, die unter den ersten Pixeln (P1) zueinander benachbart sind, angeordnet ist.

4. Anzeigevorrichtung (10) nach einem der Ansprüche 1 bis 3, wobei die zweiten Pixeleinheiten (P2) jeweils mindestens zwei Pixel der gleichen Farbe einschließen.

5. Anzeigevorrichtung (10) nach einem der Ansprüche 1 bis 4, weiter umfassend eine Vielzahl von Licht emittierenden Dioden (OLED), die jeweils den ersten Pixeln (P1) und den zweiten Pixeln (P2) entsprechen,
wobei jede der Vielzahl von Licht emittierenden Dioden (OLED) eine Stapelstruktur aus einer Pixelelektrode (221), einer Emissionsschicht (222b) und einer Gegenelektrode (223) aufweist.

6. Anzeigevorrichtung (10) nach Anspruch 5, wobei ein erster Abstand (L1) zwischen Pixelelektroden (221), die jeweils Pixeln, die gleiche Farbe aufweisen, entsprechen, die unter den ersten Pixeln (P1) zueinander benachbart sind, größer ist als ein zweiter Abstand (L2) zwischen Pixelelektroden (221), die jeweils Pixeln, die gleiche Farbe aufweisen, entsprechen, die unter den zweiten Pixeln (P2) zueinander benachbart sind.

7. Anzeigevorrichtung (10) nach Anspruch 5 oder Anspruch 6, wobei:
(i) die Emissionsschichten (222b), die jeweils Pixeln derselben Farbe entsprechen, die unter den zweiten Pixeln (P2) zueinander benachbart sind, als ein einziges Stück ausgebildet sind; und/oder
(ii) die Gegenelektroden (223), die jeweils den ersten Pixeln (P1) und den zweiten Pixeln (P2) entsprechen, als ein einziges Stück ausgebildet sind und eine Öffnung (223H) entsprechend dem Transmissionsbereich (TA) einschließen.

8. Anzeigevorrichtung (10) nach einem der Ansprüche 1 bis 7, weiter umfassend eine untere Metallschicht (BML), die zwischen dem Substrat (100) und der Vielzahl von Pixeln angeordnet ist und in dem zweiten Anzeigebereich (DA2) liegt.

9. Elektronische Einrichtung (1), umfassend:
eine Anzeigevorrichtung (10), die einen ersten Anzeigebereich (DA1) und einen zweiten Anzeigebereich (DA2) einschließt; und
eine Komponente (20), die einen Transmissionsbereich (TA) des zweiten Anzeigebereichs (DA2) überlappt,
wobei die Anzeigevorrichtung (10) eine Vielzahl von Pixeln einschließt, die erste Pixel (P1) in dem ersten Anzeigebereich (DA1) und zweite Pixel (P2) in dem zweiten Anzeigebereich (DA2) einschließt,
die ersten Pixel (P1) eine sich wiederholende Anordnungsstruktur von ersten Pixeleinheiten (U1) einschließen, die jeweils eine Vielzahl von Pixeln einschließen, die unterschiedlichen Farben aufweisen, die zweiten Pixel (P2) eine sich wiederholende Anordnungsstruktur von zweiten Pixeleinheiten (U2) einschließen, die jeweils eine Vielzahl von Pixeln einschließen, die unterschiedlichen Farben aufweisen, und jeweils eine größere Anzahl von Pixeln einschließen als die Anzahl der Pixel, die in jeder der ersten Pixeleinheiten (U1) eingeschlossen sind,
die ersten Pixeleinheiten (U1) jeweils mindestens ein erstes rotes Pixel (Pr1), mindestens ein erstes grünes Pixel (Pg1) und mindestens ein erstes blaues Pixel (Pb1) einschließen,
die zweiten Pixeleinheiten (U2) jeweils mindestens ein zweites rotes Pixel (Pr2), mindestens ein zweites grünes Pixel (Pg2) und mindestens ein zweites blaues Pixel (Pb2) einschließen,
der Transmissionsbereich (TA) zwischen den wiederholt angeordneten zweiten Pixeleinheiten (U2) liegt,
ein erster Abstand (d1) zwischen Pixeln derselben Farbe, die zueinander benachbart in den ersten Pixeln (P1) angeordnet sind, größer ist als ein zweiter Abstand (d2) zwischen Pixeln derselben Farbe, die zueinander benachbart in den zweiten Pixeln (P2) angeordnet sind, und
**dadurch gekennzeichnet, dass** die Summe der Anzahl des mindestens einen zweiten roten Pixels (Pr2), der Anzahl des mindestens einen zweiten grünen Pixels (Pg2) und der Anzahl des mindestens einen zweiten blauen Pixels (Pb2) zweimal oder mehr der Summe der Anzahl des mindestens einen ersten roten Pixels (Pr1), der Anzahl des mindestens einen ersten grünen Pixels (Pg1) und der Anzahl des mindestens einen ersten blauen Pixels (Pb1) beträgt.

10. Elektronische Einrichtung (1) nach Anspruch 9, wobei:
(i) ein dritter Abstand (d3) zwischen Pixeln unterschiedlicher Farben, die zueinander benachbart in den ersten Pixeln (P1) angeordnet sind, gleich oder größer einem vierten Abstand (d4) zwischen Pixeln unterschiedlicher Farben ist, die zueinander benachbart in den zweiten Pixeln (P2) angeordnet sind; und/oder
(iii) eine Größe oder eine Form der ersten Pixel (P1) sich von einer Größe oder einer Form der zweiten Pixel (P2) unterscheidet.

11. Elektronische Einrichtung (1) nach Anspruch 9 oder 10, weiter umfassend:
eine Vielzahl von Licht emittierenden Dioden (OLED), die jeweils dem ersten Pixel (P1) und dem zweiten Pixel (P2) entsprechen; und
eine Vielzahl von Dünnfilmtransistoren (TFT), die jeweils mit einer Vielzahl von Licht emittierenden Dioden (OLED) verbunden sind.
wobei jede der Vielzahl von Licht emittierenden Dioden (OLED) eine gestapelte Struktur aus einer Pixelelektrode (221), einer Emissionsschicht (222b) und einer gegenüberliegenden Elektrode (223) aufweist, optional wobei die elektronische Einrichtung (1) weiter eine untere Metallschicht (BML) umfasst, die unterhalb der Dünnfilmtransistoren (TFT) angeordnet ist, die im zweiten Anzeigebereich (DA2) zwischen den Dünnfilmtransistoren (TFT) liegen.

12. Elektronische Einrichtung (1) nach Anspruch 11, wobei ein erster Abstand (L1) zwischen Pixelelektroden (221), die jeweils Pixeln gleicher Farbe entsprechen, die unter den ersten Pixeln (P1) zueinander benachbart sind, größer ist als ein zweiter Abstand (L2) zwischen Pixelelektroden (221), die jeweils Pixeln gleicher Farbe entsprechen, die unter den zweiten Pixeln (P2) zueinander benachbart sind.

13. Elektronische Einrichtung (1) nach Anspruch 11 oder Anspruch 12, wobei die Emissionsschichten (222b), die jeweils Pixeln derselben Farbe entsprechen, die unter den zweiten Pixeln (P2) zueinander benachbart sind, als ein einziges Stück ausgebildet sind, optional wobei das einziges Stück der Emissionsschichten eine Oberseite einer Pixeldefinierungsschicht (119) bedeckt, wobei die Pixeldefinierungsschicht (119) Ränder von Pixelelektroden (221) bedeckt, die jeweils Pixeln derselben Farbe entsprechen, die unter den zweiten Pixeln (P2) zueinander benachbart sind.

14. Elektronische Einrichtung (1) nach einem der Ansprüche 9 bis 13, wobei:
(i) ein Pixel einer anderen Farbe zwischen Pixeln derselben Farbe liegt, die unter den ersten Pixeln (P1) zueinander benachbart sind; und/oder
(ii) die Komponente (20) einen Sensor oder eine Kamera einschließt.

## Revendications

1. Dispositif d'affichage (10) incluant une zone d'affichage (DA) et une zone non d'affichage (NDA) entourant la zone d'affichage (DA), la zone d'affichage (DA) incluant une première zone d'affichage (DA1) et une seconde zone d'affichage (DA2), le dispositif d'affichage (10) comprenant :
un substrat (100) ; et
une pluralité de pixels agencés sur le substrat (100) et incluant des premiers pixels (P1) et des seconds pixels (P2), les premiers pixels (P1) étant inclus dans la première zone d'affichage (DA1) et les seconds pixels (P2) étant inclus dans la seconde zone d'affichage (DA2),
dans lequel les premiers pixels (P1) incluent une structure d'agencement de répétition de premières unités de pixels (U1) incluant chacune une pluralité de pixels présentant des couleurs différentes, et les seconds pixels (P2) incluent une structure d'agencement de répétition de secondes unités de pixels (U2) incluant chacune une pluralité de pixels présentant des couleurs différentes et incluant chacune un nombre de pixels supérieur au nombre de pixels inclus dans chacune des premières unités de pixels (U1),
les premières unités de pixels (U1) incluent chacune au moins un premier pixel rouge (Pr1), au moins un premier pixel vert (Pg1) et au moins un premier pixel bleu (Pb1),
les secondes unités de pixels (U2) incluent chacune au moins un second pixel rouge (Pr2), au moins un second pixel vert (Pg2) et au moins un second pixel bleu (Pb2).
la seconde zone d'affichage (DA2) inclut une zone de transmission (TA) entre les secondes unités de pixels (U2) qui sont agencées de manière répétée,
une première distance (d1) entre des pixels de la même couleur qui sont voisins parmi les premiers pixels (P1) est supérieure à une deuxième distance (d2) entre des pixels de la même couleur qui sont voisins parmi les seconds pixels (P2), et
**caractérisé en ce que** la somme du nombre du au moins un second pixel rouge (Pr2), du nombre du au moins un second pixel vert (Pg2) et du nombre du au moins un second pixel bleu (Pb2) est deux fois ou plus égale à la somme du nombre du au moins un premier pixel rouge (Pr1), du nombre du au moins un premier pixel vert (Pg1) et du nombre du au moins un premier pixel bleu (Pb1).

2. Dispositif d'affichage (10) selon la revendication 1, dans lequel une troisième distance (d3) entre des pixels de couleurs différentes qui sont voisins parmi les premiers pixels (P1) est égale ou supérieure à une quatrième distance (d4) entre des pixels de couleurs différentes qui sont voisins parmi les seconds pixels (P2).

3. Dispositif d'affichage (10) selon la revendication 1 ou la revendication 2, dans lequel :
(i) une taille ou une forme des premiers pixels (P1) est différente d'une taille ou d'une forme des seconds pixels (P2) ; et/ou
(ii) un pixel d'une couleur différente est agencé entre des pixels de la même couleur qui sont voisins parmi les premiers pixels (P1).

4. Dispositif d'affichage (10) selon l'une quelconque des revendications 1 à 3, dans lequel les secondes unités de pixels (P2) incluent chacune au moins deux pixels de la même couleur.

5. Dispositif d'affichage (10) selon l'une quelconque des revendications 1 à 4, comprenant en outre une pluralité de diodes électroluminescentes (OLED) correspondant respectivement aux premiers pixels (P1) et aux seconds pixels (P2),
dans lequel chacune de la pluralité de diodes électroluminescentes (OLED) présente une structure empilée d'une électrode de pixel (221), d'une couche d'émission (222b) et d'une électrode opposée (223).

6. Dispositif d'affichage (10) selon la revendication 5, dans lequel une première distance de séparation (L1) entre des électrodes de pixel (221) correspondant respectivement à des pixels présentant la même couleur qui sont voisins parmi les premiers pixels (P1) est supérieure à une deuxième distance de séparation (L2) entre des électrodes de pixel (221) correspondant respectivement à des pixels présentant la même couleur qui sont voisins parmi les seconds pixels (P2).

7. Dispositif d'affichage (10) selon la revendication 5 ou la revendication 6, dans lequel :
(i) les couches d'émission (222b) correspondant respectivement à des pixels de la même couleur qui sont voisins parmi les seconds pixels (P2) sont formées sous la forme d'un corps unique ; et/ou
(ii) les électrodes opposées (223) correspondant respectivement aux premiers pixels (P1) et aux seconds pixels (P2) sont formées sous la forme d'un corps unique et incluent un trou (223H) correspondant à la zone de transmission (TA).

8. Dispositif d'affichage (10) selon l'une quelconque des revendications 1 à 7, comprenant en outre une couche métallique inférieure (BML) agencée entre le substrat (100) et la pluralité de pixels et située dans la seconde zone d'affichage (DA2).

9. Appareil électronique (1), comprenant :
un dispositif d'affichage (10) incluant une première zone d'affichage (DA1) et une seconde zone d'affichage (DA2) ; et
un composant (20) chevauchant une zone de transmission (TA) de la seconde zone d'affichage (DA2),
dans lequel le dispositif d'affichage (10) inclut une pluralité de pixels incluant des premiers pixels (P1) dans la première zone d'affichage (DA1) et des seconds pixels (P2) dans la seconde zone d'affichage (DA2),
les premiers pixels (P1) incluent une structure d'agencement de répétition de premières unités de pixels (U1) incluant chacune une pluralité de pixels présentant des couleurs différentes, les seconds pixels (P2) incluent une structure d'agencement de répétition de secondes unités de pixels (U2) incluant chacune une pluralité de pixels présentant des couleurs différentes et incluant chacune un nombre de pixels supérieur au nombre de pixels inclus dans chacune des premières unités de pixels (U1),
les premières unités de pixels (U1) incluent chacune au moins un premier pixel rouge (Pr1), au moins un premier pixel vert (Pg1) et au moins un premier pixel bleu (Pb1).
les secondes unités de pixels (U2) incluent chacune au moins un second pixel rouge (Pr2), au moins un second pixel vert (Pg2) et au moins un second pixel bleu (Pb2). la zone de transmission (TA) se situe entre les secondes unités de pixels (U2) qui sont agencées de manière répétée,
une première distance (d1) entre des pixels de la même couleur qui sont voisins parmi les premiers pixels (P1) est supérieure à une deuxième distance (d2) entre des pixels de la même couleur qui sont voisins parmi les seconds pixels (P2), et
**caractérisé en ce que** la somme du nombre du au moins un second pixel rouge (Pr2), du nombre du au moins un second pixel vert (Pg2) et du nombre du au moins un second pixel bleu (Pb2) est deux fois ou plus égale à la somme du nombre du au moins un premier pixel rouge (Pr1), du nombre du au moins un premier pixel vert (Pg1) et du nombre du au moins un premier pixel bleu (Pb1).

10. Appareil électronique (1) selon la revendication 9, dans lequel :
(i) une troisième distance (d3) entre des pixels de couleurs différentes qui sont voisins parmi les premiers pixels (P1) est égale ou supérieure à une quatrième distance (d4) entre des pixels de couleurs différentes qui sont voisins parmi les seconds pixels (P2) ; et/ou
(i) une taille ou une forme des premiers pixels (P1) est différente d'une taille ou d'une forme des seconds pixels (P2) .

11. Appareil électronique (1) selon la revendication 9 ou 10, comprenant en outre :
une pluralité de diodes électroluminescentes (OLED) correspondant respectivement aux premiers pixels (P1) et aux seconds pixels (P2) ; et
une pluralité de transistors à couches minces (TFT) connectés respectivement à une pluralité de diodes électroluminescentes (OLED),
dans lequel chacune de la pluralité de diodes électroluminescentes (OLED) présente une structure empilée d'une électrode de pixel (221), d'une couche d'émission (222b) et d'une électrode opposée (223), dans lequel l'appareil électronique (1) comprend en outre une couche métallique inférieure (BML) agencée sous des transistors à couches minces (TFT) situés dans la seconde zone d'affichage (DA2) parmi les transistors à couches minces (TFT).

12. Appareil électronique (1) selon la revendication 11, dans lequel une première distance de séparation (L1) entre des électrodes de pixel (221) correspondant respectivement à des pixels de la même couleur qui sont voisins parmi les premiers pixels (P1) est supérieure à une deuxième distance de séparation (L2) entre des électrodes de pixel (221) correspondant respectivement à des pixels de la même couleur qui sont voisins parmi les seconds pixels (P2).

13. Appareil électronique (1) selon la revendication 11 ou la revendication 12, dans lequel les couches d'émission (222b) correspondant respectivement à des pixels de la même couleur qui sont voisins parmi les seconds pixels (P2) sont formées sous la forme d'un corps unique, facultativement dans lequel le corps unique des couches d'émission recouvre une surface supérieure d'une couche de définition de pixel (119), la couche de définition de pixel (119) recouvrant des bords des électrodes de pixel (221) correspondant respectivement à des pixels de la même couleur qui sont voisins parmi les seconds pixels (P2).

14. Appareil électronique (1) selon l'une quelconque des revendications 9 à 13, dans lequel :
(i) un pixel d'une couleur différente est situé entre des pixels de la même couleur qui sont voisins parmi les premiers pixels (P1) ; et/ou
(ii) le composant (20) inclut un capteur ou une caméra.
